# EUROPEAN PATENT APPLICATION

(11) **EP 3 922 681 A1**
(43) Date of publication of application: **15.12.2021**
(21) Application number: 21182431.3
(22) Date of filing: 19.06.2019
(51) Int. Cl.: C09B 67/22, C09B 67/46, G02F 1/1335, G03F 7/00, C09B 57/00, B41M 3/14, G03F 7/105

(54) **RED PIGMENT COMPOSITION FOR COLOR FILTER**

(30) Priority: 25.06.2018 EP 18179550
(62) Divisional of application: 19735227.1
(71) Applicant: BASF SE, 67056 Ludwigshafen am Rhein (DE)
(72) Inventor: LENZ, Roman, 4410 Liestal (CH); DE KEYZER, Gerardus, 4057 Basel (CH); HORNI, Thomas, 4057 Basel (CH)
(74) Representative: Altmann Stößel Dick Patentanwälte PartG mbB

(57) **Abstract**

Disclosed is a pigment composition which comprises (a) a pigment of formula (I) 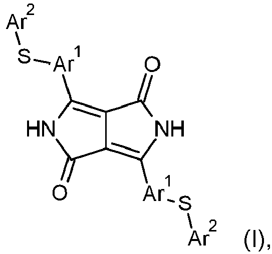 wherein Ar¹ is phenylene or C₂-C₆-heteroarylene, Ar² is C₆-C₁₀-aryl or C₂-C₆-heteroaryl;
and (b) a pigment derivative of formula (XII) 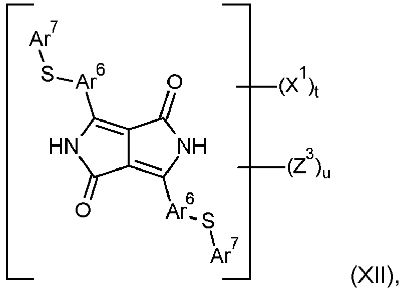 X¹ is a group comprising an aliphatic carboxamide group or an aliphatic sulfonamide group.
The pigment composition is suitable to color organic material, especially photosensitive resist formulations for use in color filter applications having high contrast ratios.

## Description

The present invention relates to a pigment composition comprising an arylthio-substituted diketopyrrolopyrrole pigment and at least one pigment derivative comprising a polar group, and to an arylthiol-substituted diketopyrrolopyrrole pigment derivative. The pigment composition is suitable to color organic material, especially photosensitive resist formulations for use in color filter applications.

### BACKGROUND OF THE INVENTION

In case of color filters, a hue conforming to relevant standards and high contrast ratio are essential. However, it is often difficult to achieve the desired color point and a good contrast ratio, especially when the color filter is to be cured at a temperature of 200°C or higher. The application of said temperatures often affects adversely the desired contrast ratio.

Contrast ratio (CR) is measured by determining the light intensity after irradiation through a pigmented coating layer on a transparent substrate placed between two polarizers. Contrast ratio is the ratio of the light intensities for parallel and perpendicular polarizers.

C.I. (Color Index) Pigment Red 177 is a widely used bluish red anthraquinone pigment in photosensitive resin compositions for color filter applications. However, Pigment Red 177 suffers from a low tinctorial strength, i.e., relatively thick layers are needed to obtain the desired saturation.

A further bluish red pigment based on a diketopyrrolopyrrole chromophore is disclosed in WO-A-04/007604, wherein a phenylthio-substituted diketopyrrolopyrrole pigment is described providing a transparent blue-tinged red coloration in PVC. Specifically, WO-A-04/007604 discloses a color filter produced with a phenyl-thio-substituted diketopyrrolopyrrole pigment and further three pigment derivatives - a sulfonated diketopyrrolopyrrole derivative, a dihydroquinacridone derivative and Solsperse^{®} 22'000 (a yellow pigment derivative). The color filters are described having a high transmission of color dots.

WO-A-05/040284 discloses a pigment mixture produced by reacting 0.50 mol of 4-phenylthiobenzonitrile and 0.005 mol of 4-octadecylthiobenzonitrile. The pigment mixture is described to exhibit a transparent, tinctorially strong red coloration in PVC.

However, the pigment compositions based on phenylthio-substituted diketopyrrolopyrrole pigments do not meet all requirements necessary for color filter applications, for example, high color saturation, precise color point, high transmittance, a high contrast ratio, thermal stability, ease of processibility, like high dispersibility and high dispersion stability.

Hence, there is a continuing need for a red pigment composition which suitably overcomes the above-mentioned disadvantages.

Therefore, it is an object of the present invention to provide a pigment composition for producing a color filter which exhibits improved coloristic properties, especially a high contrast ratio, when subjected to a thermal treatment during the processing phase (from application of the dispersion to complete hardening).

Further, it is an object of the present invention to provide a pigment composition for producing a color filter, which is easily processible and/or is easily available.

Further, it is an object of the present invention to provide a pigment derivative suitable as a growth inhibitor and / or synergist in pigment compositions, especially comprising a diketopyrrolopyrrole pigment.

### SUMMARY OF THE INVENTION

It has now been found that a pigment composition based on a thioaryl-substituted diketopyrrolopyrrole pigment meet the desired characteristics.

Accordingly, in a first aspect the invention relates to a pigment composition comprising
(a) a pigment of formula 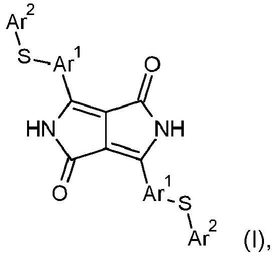 wherein
   Ar¹ is at each occurrence selected from phenylene or C₂-C₆-heteroarylene, said phenylene or heteroarylene is unsubstituted or substituted with R¹;
   Ar² is at each occurrence selected from C₆-C₁₀-aryl or C₂-C₆-heteroaryl, said aryl or heteroaryl is unsubstituted or substituted with R² and/or R³;
   R¹ is at each occurrence selected from Cl, Br, C₁-C₄-alkyl, OC₁-C₄-alkyl, CF₃ or CN;
   R² and R³ are independently of one another and at each occurrence selected from Cl, Br, C₁-C₄-alkyl, OC₁-C₄-alkyl, CF₃ orCN; or
   two adjacent R² and R³ together with the aryl or heteroaryl ring to which they are bonded form an aromatic or heteroaromatic 5- or 6-membered ring, said aromatic or heteroaromatic ring is unsubstituted or substituted with R⁴,
   R⁴ is Cl or C₁-C₄-alkyl; and
(b) a pigment derivative of formula

   (P¹) - (X¹)ₘ (II)

   , wherein
   P¹ is a residue of a colorant chromophore,
   X¹ is a group comprising an aliphatic carboxamide group, an aliphatic sulfonamide group, a carboxylic acid group or salt thereof, and
   m is 1, 2, 3 or 4.

In a further aspect, the invention relates to a process for preparing said pigment composition as well as to the use of said pigment composition for coloring a photosensitive resist formulation for manufacturing a color filter, a printing ink, a liquid ink, a coating composition, a paint, plastics, a film or a fiber.

In a further aspect, the invention relates to a pigment dispersion as well as to a photosensitive resist formulation comprising said pigment composition and a color filter manufactured by using the photosensitive resist formulation.

In a further aspect, the invention relates to an arylthiol-substituted diketopyrrolopyrrole pigment derivative.

### DETAILED DESCRIPTION OF THE INVENTION

The term "residue of a colorant chromophore" used herein for P¹, P² or P³ means a residue derived from a colorant chromophore by abstracting a hydrogen, preferably from an aromatic hydrogen. The colorant chromophore P¹, P² or P³ may be substituted.

The residue of a colorant chromophore may be derived from a diketopyrrolopyrrole, a quinacridone, a dihydroquinacridone, a quinacridonequinone, an anthraquinone, an anthanthrone, an aminoanthraquinone, a benzimidazolone, a quinophthalone, a disazo, an azo, an isoinoline, an isoindolinone, a perylene or a perinone, preferably a diketopyrrolopyrrole, a quinacridone, a dihydroquinacridone, a quinacridonequinone, an anthraquinone, an aminoanthraquinone or a perylene.

Alkyl, e.g., C₁-C₁₈-alkyl, C₁-C₄-alkyl, C₁-C₆-alkyl, C₄-C₂₅-alkyl or C₈-C₂₂-alkyl, may be within the given limits of carbon atoms linear or branched, where possible. Examples are methyl (Me), ethyl (Et), n-propyl, isopropyl, n-butyl, s-butyl, isobutyl, t-butyl, n-pentyl, 2-pentyl, 3-pentyl, 2,2-dimethylpropyl, n-hexyl, 1-methylhexyl, n-heptyl, isoheptyl, 1,1,3,3-tetramethylbutyl, 1-methylheptyl, 3-methylheptyl, n-octyl, 2-ethylhexyl, n-nonyl, n-decyl, n-undecyl, n-dodecyl, n-tridecyl, n-tetradecyl, n-pentadecyl, n-hexadecyl, n-heptadecyl, n-octadecyl, n-eicosyl, n-heneicosyl, n-docosyl (behenyl), n-tetracosyl (lignoceryl), n-pentacosyl and constitutional isomers of the aforementioned n-alkyl radicals.

Alkylene, e.g., C₁-C₄-alkylene, C₁-C₆-alkylene, may be derived from above-defined alkyl by abstracting a hydrogen atom from any terminal carbon atom of the alkyl.

Aralkyl, e.g., C₇-C₂₅-aralkyl or C₁₂-C₂₂-aralkyl, may be within the given limits of carbon atoms, for example, benzyl, 2-benzyl-2-propyl, β-phenyl-ethyl (phenethyl), α,α-dimethylbenzyl, ω-phenyl-butyl, ω,ω-dimethyl-ω-phenyl-butyl, ω-phenyl-dodecyl, in which both the aliphatic and the aromatic hydrocarbon group may be unsubstituted or substituted. Preferred examples are benzyl, phenethyl, α,α-dimethylbenzyl, ω-phenyl-butyl, ω-phenyl-dodecyl and ω-phenyl-octadecyl.

Alkylaryl, e.g., C₇-C₂₅-alkylaryl or C₁₂-C₂₂-alkylaryl, may be within the given limits of carbon atoms, for example, phenyl p- or m-substituted with C₁-C₁₉-alkyl.

Aryl, e.g., C₆-C₁₀-aryl or C₆-C₁₂-aryl, may be within the given limits of carbon atoms phenyl, 1- naphthyl, 2-naphthyl or biphenylyl.

Heteroaryl may be C₂-C₆-heteroaryl or C₂-C₅-heteroaryl, i.e., a ring with five to seven ring atoms, wherein nitrogen, oxygen or sulfur are the possible heteroatoms. Examples are thienyl, furyl, pyrrolyl, imidazolyl, pyrazolyl, thiazolyl, oxazolyl, pyridyl, triazinyl or pyrimidinyl.

Heteroarylene, e.g., C₂-C₆-heteroarylene, may be derived from above-defined heteroaryl by abstracting a hydrogen atom from any ring carbon atom of the heteroaryl.

Halogen (Hal) denotes I, Br, Cl, or F, preferably F or Cl on alkyl and Cl or Br on aryl.

Examples of an aromatic or heteroaromatic ring, preferably a 5- or 6-membered ring, formed by, for example, R² and R³ together with the aryl or heteroaryl ring to which they are bonded, are a benzoannelated ring or pyridine.

Examples of a 5- or 6-membered ring formed by G and R⁵ or R⁶ and R⁷ are heterocycloalkanes or heterocycloalkenes having 3 to 6 carbon atoms and optionally one additional hetero atom selected from O, S or NR⁸.

Suitable examples are

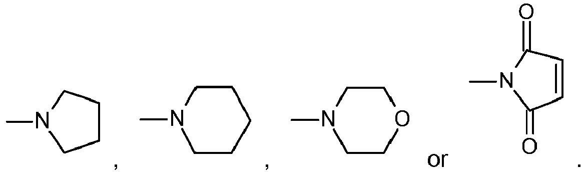

A residue of a colorant chromophore may be derived from a colorant chromophore by abstracting a hydrogen atom from any carbon or nitrogen atom of the chromophore.

The term "substituted" means "substituted one or more times with", i.e., 1 to 3 times, where possible, preferably 1 or 2 times, more preferably 1. If a substituent occurs more than once in a group, it may be different at each occurrence.

A pigment of formula (I) is preferably characterized by the following groups:
Ar¹ is preferably 1,4-phenylene or C₃-C₅-heteroarylene, said phenylene may be substituted by R¹ selected from Cl, CH₃, C₂H₅, OCH₃ or OC₂H₅, more preferably from Cl, CH₃ or OCH₃. C₃-C₅-heteroarylene may comprise 1, 2 or 3 nitrogen atoms. Examples of C₃-C₅-heteroarylene may be pyridine-2,5-diyl, pyridine-3,6-diyl and pyrimidine-2,5-diyl.

More preferably, Ar¹ is 1,4-phenylene which is unsubstituted or substituted with Cl, CH₃, OCH₃, or pyridine-2,5-diyl, most preferably 1,4-phenylene.

Ar² is preferably phenyl or 1-naphthyl or 2-naphthyl, said groups are unsubstituted or substituted with R² and/or R³, wherein R² and R³ are independently of one another Cl, CH₃ or OCH₃.

Ar² may also be heteroaryl, for example, 2-thiazole, 2-imidazole, 2-benzothiazole or 2-benzoimidazole. Said heteroaryl groups may be substituted with one or more Cl or CH₃. More preferably, Ar² is phenyl, phenyl p-substituted with Cl, CH₃ or OCH₃, or 2-benzothiazole.

Accordingly, a pigment of formula (I) is preferred, wherein
Ar¹ is at each occurrence selected from 1,4-phenylene or C₃-C₅-heteroarylene, said phenylene is unsubstituted or substituted with R¹;
Ar² is at each occurrence selected from phenyl or C₃-C₅-heteroaryl, said phenyl or heteroaryl is unsubstituted or substituted with R² and/or R³;
R¹ is selected from Cl, CH₃ or OCH₃;
R² and R³ are independently of one another and at each occurrence selected from Cl, CH₃ or OCH₃; or
R² and R³ together with the aryl or heteroaryl ring to which they are bonded form an aromatic or heteroaromatic 5- to 6-membered ring.

Accordingly, a pigment of formula (I) is more preferred, wherein
Ar¹ is independently of one another 1,4-phenylene; 1,4-phenylene substituted with Cl, CH₃, OCH₃; or pyridine-2,5-diyl, preferably 1,4-phenylene; and
Ar² is independently of one another phenyl; phenyl p-substituted with Cl, CH₃ or OCH₃; 2-benzothiazole or 6-methyl-2-benzothiazole; preferably phenyl or phenyl p-substituted with Cl, CH₃ or OCH₃.

In particular, both groups of Ar¹ are the same, and both groups of Ar² are the same.

Suitable examples of the pigment of formula (I) are 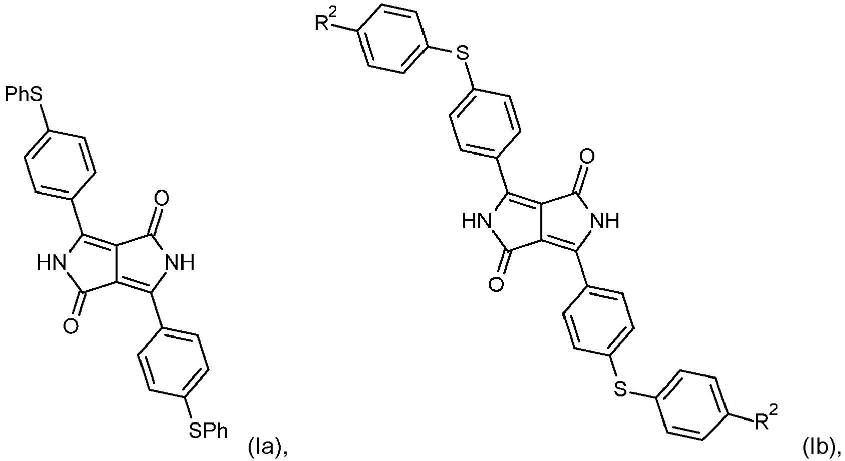 wherein R² is Cl, CH₃ or OCH₃; and

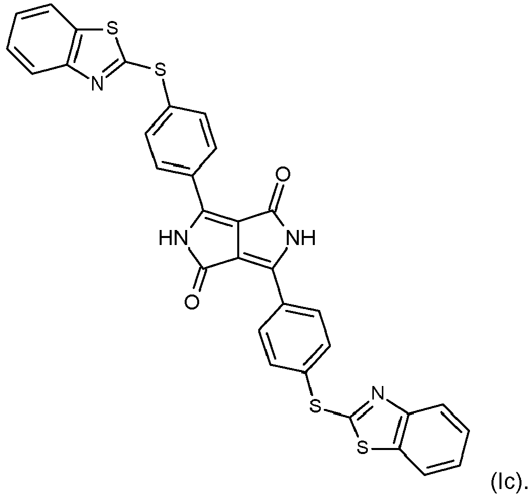

The pigment derivative of formula

(P¹) - (X¹)ₘ (II)

is preferred, wherein P¹ is a residue of a colorant chromophore selected from the group consisting of a diketopyrrolopyrrole, a quinacridone, a dihydroquinacridone, a quinacridonequinone, an aminoanthraquinone and a perylene, preferably selected from the group consisting of a 3,6-diphenyl-2,5-dihydropyrrolo[3,4-c]pyrrole-1,4-dione, a quinacridone, a 6,13-dihydroquinacridone, a quinacridonequinone, a 4,4'-diamino-1,1'-bisanthraquinone, a perylenetetracarboxylic acid dianhydride and a perylenetetracarboxylic acid diimide. The chromophore may be unsubstituted or substituted.

The substituents of P¹ are customary substituents of colorant chromophores, for example, halogen, C₁-C₄-alkyl, OC₁-C₄-alkyl, CF₃, CN, SC₁-C₄alkyl, Ar³, OAr³ or SAr³, especially Cl, Br, methyl, ethyl, t-butyl, phenyl, OAr³ or SAr3.

Preferably, P¹ is a residue of a 3,6-diphenyl-2,5-dihydropyrrolo[3,4-c]pyrrole-1,4-dione, a quinacridone, a 6,13-dihydroquinacridone or a 4,4'-diamino-1,1'-bisanthraquinone chromophore, which is unsubstituted or substituted, preferably unsubstituted or substituted by Cl, Br, methyl, ethyl, propyl, iso-propyl, n-butyl, t-butyl, phenyl, OAr³ or SAr³, more preferably unsubstituted or substituted by CI, Br, methyl, ethyl, t-butyl, phenyl, phenoxy or S-phenyl.

The substituent X¹ may be a polar group of formula

-A¹-D-G (III)

or a group of formula -A²-E (IV), wherein A¹ and A² may be a direct covalent bond to the colorant chromophore P¹ or a linking group of C₁-C₄-alkylene.

Accordingly, the pigment composition is preferred, wherein the pigment derivative is of formula (II), wherein X¹ is a group of formula

- A¹ - D - G (III)

or

- A² - E (IV)

, wherein
A¹ and A² are independently of one another a direct bond or C₁-C₄-alkylene;
D is -NH-CO-, -NH-SO₂-, -CO-NR⁵- or -SO₂-NR⁵-;
G is -(C₁-C₆-alkylene)-NR⁶R⁷ or-(C₁-C₆-alkylene)-NH-NR⁶R⁷, said C₁-C₆-alkylene may be interrupted by -NH-;
R⁵ is H;
or G and R⁵ together with the linking nitrogen form a 5- or 6-membered ring, said 5- or 6-membered ring is unsubstituted or substituted with C₁-C₄-alkyl and/or interrupted by NR⁸, O or S;
R⁶ and R⁷ are independently of one another H or C₁-C₄-alkyl;
or R⁶ and R⁷ together with the linking nitrogen form a 5- or 6-membered ring, said 5- or 6-membered ring is unsubstituted or substituted with C₁-C₄-alkyl and/or interrupted by NR⁸, O or S;
R⁸ is H or C₁-C₄-alkyl; and
E is C₆-C₁₂-aryl substituted with CO₂H or a salt thereof.

Preferably, X¹ is a group of formula - A¹ - D - G

(III) ,

wherein
A¹ is a direct bond or C₁-C₄-alkylene, preferably a direct bond or methylene;
D is -NH-CO-, -CO-NR⁵- or -SO₂-NR⁵-;
G is -(C₁-C₆-alkylene)-NR⁶R⁷ or -(C₁-C₆-alkylene)-NH-NR⁶R⁷, said C₁-C₆-alkylene may be interrupted by -NH-;
R⁵ is H;
or G and R⁵ together with the linking nitrogen form a 5- or 6-membered ring, said 5- or 6-membered ring is unsubstituted or substituted with C₁-C₄-alkyl and/or interrupted by NR⁸, O or S;
R⁶ and R⁷ are independently of one another H or C₁-C₄-alkyl;
or R⁶ and R⁷ together with the linking nitrogen form a 5- or 6-membered ring, said 5- or 6- membered ring is unsubstituted or substituted with C₁-C₄-alkyl and/or interrupted by NR⁸, O or S; and
R⁸ is H or C₁-C₄-alkyl.

In a preferred aspect, the pigment derivative of formula

(P¹) - (X¹)ₘ (II)

is a diketopyrrolopyrrole derivative of formula 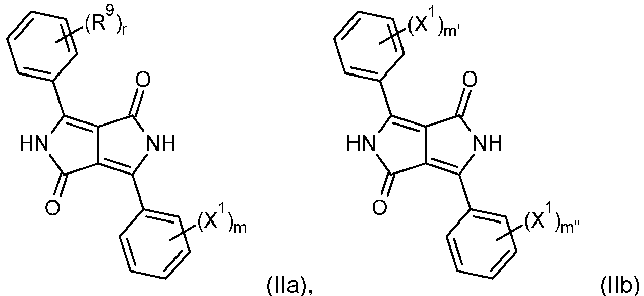 or 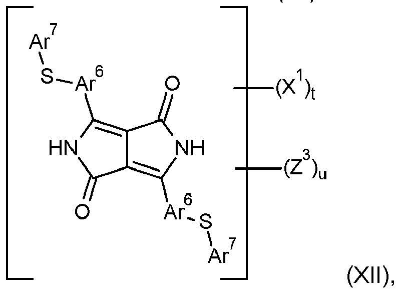 wherein
m is 1 or 2, preferably 1;
m' and m" are independently of one another 1 or 2;
r is 0, 1 or 2;
R⁹ is at each occurrence selected from Cl, Br, CF₃, CN, C₁-C₄-alkyl, OC₁-C₄-alkyl, SC₁-C₄-alkyl, Ar³, OAr³ or SAr³;
Ar³ is C₆-C₁₀-aryl or C₂-C₆-heteroaryl, said aryl or heteroaryl is unsubstituted or substituted with R¹⁰ and/or R¹¹;
R¹⁰ and R¹¹ are independently of one another Cl, Br, C₁-C₄-alkyl, OC₁-C₄-alkyl, CF₃ or CN; or
R¹⁰ and R¹¹ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
X¹ is a group of formula

   -A¹-D-G (III)

   ;
A¹ is a direct bond or C₁-C₄-alkylene;
D is -NH-CO-, -CO-NR⁵- or -SO₂-NR⁵-;
G is -(C₁-C₆-alkylene)-NR⁶R⁷ or -(C₁-C₆-alkylene)-NH-NR⁶R⁷, said C₁-C₆-alkylene may be interrupted by -NH-;
R⁵ is H;
or G and R⁵ together with the linking nitrogen form a 5- or 6-membered ring, said 5- or 6-membered ring is unsubstituted or substituted with C₁-C₄-alkyl and/or interrupted by NR⁸, O or S;
R⁶ and R⁷ are independently of one another H or C₁-C₄-alkyl;
or R⁶ and R⁷ together with the linking nitrogen form a 5- or 6-membered ring, said 5- or 6- membered ring is unsubstituted or substituted with C₁-C₄-alkyl and/or interrupted by NR⁸, O or S;
R⁸ is H or C₁-C₄-alkyl;
Ar⁶ is at each occurrence selected from phenylene or C₂-C₆-heteroarylene, said phenylene or heteroarylene is unsubstituted or substituted with R²²;
R²² is Cl, Br, C₁-C₄-alkyl, OC₁-C₄-alkyl, CF₃ or CN;
Ar⁷ is at each occurrence selected from C₆-C₁₀-aryl or C₂-C₆-heteroaryl, said aryl or heteroaryl is unsubstituted or substituted with R²³ and/or R²⁴;
R²³ and R²⁴ are independently of one another Cl, Br, C₁-C₄-alkyl, OC₁-C₄-alkyl, CF₃ or CN; or
R²³ and R²⁴ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Z² is SO₃H or a salt thereof;
t is a number of 1 to 4, preferably a number of 1 to 3;
u is a number of 0 to 3, preferably a number of 0 to 2; and
with the proviso that t+u is 1 to 4.

More preferably, the pigment derivative is of formula (IIa) or of formula (XII). Especially, the pigment derivative is of formula (IIa), wherein R⁹ is p-substituted.

A suitable pigment derivative is of formula (II), preferably of formula (IIa), (IIb) or (XII), more preferably of formula (IIa), wherein
X¹ is a group of formula

   -A¹-D-G (III)

   ;
A¹ is a direct bond or methylene;
D is -NH-CO-, -CO-NR⁵- or -SO₂-NR⁵-;
G is -(C₁-C₄-alkylene) - NR⁶R⁷, said C₁-C₄-alkylene may be interrupted by -NH-;
R⁵ is H;
or G and R⁵ together with the linking nitrogen form a 6-membered ring, said 6-membered ring may be substituted by C₁-C₄-alkyl and/or interrupted by NR⁸, O or S;
R⁶ and R⁷ are independently from one another H or C₁-C₄-alkyl;
or R⁶ and R⁷ together with the linking nitrogen form a 5- or 6-membered ring, said ring may be substituted by C₁-C₄-alkyl and/or interrupted by NR⁸, O or S; and
R⁸ is H or C₁-C₄-alkyl.

Preferably, G is -(C₁-C₄-alkylene) - NR⁶R⁷, said C₁-C₄-alkylene may be interrupted by - NH-;
R⁶ and R⁷ are independently of one another H or C₁-C₄-alkyl;
or R⁶ and R⁷ together with the linking nitrogen form a 6-membered ring, said 6-membered ring may be substituted by C₁-C₄-alkyl and/or interrupted by NR⁸, O or S; and
R⁸ is H or C₁-C₄-alkyl.

Preferred groups of formula

-A'-D-G (III)

are, for example, -SO₂NH(CH₂)₃N(CH₃)₂, - SO₂NH(CH₂)₃N(C₂H₅)₂, SO₂NH(CH₂)₃N(nC₄H₉)₂, -CONH(CH₂)₃N(CH₃)₂, - CONH(CH₂)₃N(C₂H₅)₂, -CONH(CH₂)₃N(nC₄H₉)₂,

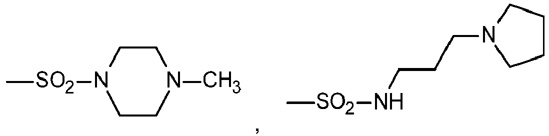

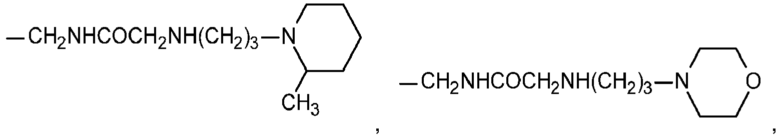

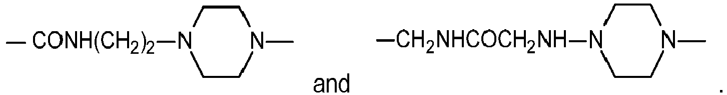

In a preferred aspect, the pigment derivative of formula (P¹) - (X¹)ₘ (II) is a diketopyrrolopyrrole derivative of formula 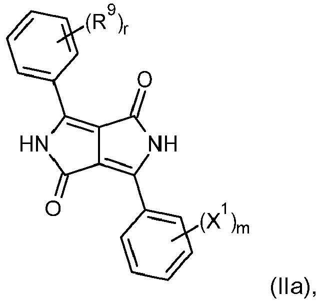 wherein
m is 1 or 2, preferably 1;
r is 0, 1 or 2, preferably 0 or 1;
R⁹ is at each occurrence selected from Cl, Br, CF₃, CN, C₁-C₄-alkyl, OC₁-C₄-alkyl, SC₁-C₄-alkyl, Ar³, OAr³ or SAr³;
Ar³ is C₆-C₁₀-aryl or C₂-C₆-heteroaryl, said aryl or heteroaryl is unsubstituted or substituted with R¹⁰ and/or R¹¹;
R¹⁰ and R¹¹ are independently of one another Cl, Br, C₁-C₄-alkyl, OC₁-C₄-alkyl, CF₃ or CN; or
R¹⁰ and R¹¹ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
X¹ is a group of formula

   -A¹-D-G (III)

   , wherein
A¹ is a direct bond or methylene;
D is -NHCO-, -CO-NR⁵- or -SO₂-NR⁵-;
G is -(C₁-C₄-alkylene)-NR⁶R⁷, said C₁-C₄-alkylene may be interrupted by -NH-;
R⁵ is H;
or G and R⁵ together with the linking nitrogen form a 6-membered ring, said 6-membered ring may be substituted by C₁-C₄-alkyl and/or interrupted by NR⁸, O or S; R⁶ and R⁷ are independently of one another H or C₁-C₄-alkyl;
or R⁶ and R⁷ together with the linking nitrogen form a 6-membered ring, said 6-membered ring may be substituted by C₁-C₄-alkyl and/or interrupted by NR⁸, O or S; and
R⁸ is H or C₁-C₄-alkyl.

More preferred is a pigment derivative of formula (IIa), wherein
r is 1;
R⁹ is p-substituted, especially p-substituted with R⁹ being Cl, Br, Me, OMe, phenyl, phenoxy or SAr³;
A¹ is a direct bond;
D is -CO-NR⁵- or -SO₂-NR⁵-; and
Ar³ is phenyl; phenyl which is p-substituted with Cl, CH₃ or OCH₃; 2-benzothiazole or 6-methyl-2-benzothiazole, preferably phenyl or phenyl which is p-substituted with Cl, CH₃ or OCH₃.

In a further preferred aspect, the pigment derivative of formula

(P¹) - (X¹)ₘ (II)

is a diketopyrrolopyrrole derivative of formula 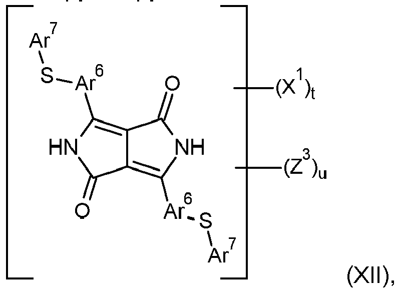 wherein
X¹ is a group of formula

   -A¹-D-G (III)

   ;
A¹ is a direct bond or methylene, especially a direct bond;
D is -NH-CO-, -CO-NR⁵- or -SO₂-NR⁵-, especially -SO₂-NR⁵-;
G is -(C₁-C₄-alkylene) - NR⁶R⁷, said C₁-C₄-alkylene may be interrupted by -NH-;
R⁵ is H;
or G and R⁵ together with the linking nitrogen form a 6-membered ring, said 6-membered ring may be substituted by C₁-C₄-alkyl and/or interrupted by NR⁸, O or S; R⁶ and R⁷ are independently from one another H or C₁-C₄-alkyl;
or R⁶ and R⁷ together with the linking nitrogen form a 6-membered ring, said 6-membered ring may be substituted by C₁-C₄-alkyl and/or interrupted by NR⁸, O or S; R⁸ is H or C₁-C₄-alkyl;
Ar⁶ is at each occurrence selected from 1,4-phenylene or C₃-C₅-heteroarylene, said phenylene is unsubstituted or substituted with R²²;
Ar⁷ is at each occurrence selected from phenyl or C₃-C₅-heteroaryl, said phenyl or heteroaryl is unsubstituted or substituted with R²³ and/or R²⁴;
R²² is at each occurrence selected from Cl, CH₃ or OCH₃;
R²³ and R²⁴ are independently of one another and at each occurrence selected from Cl, CH₃ or OCH₃; or
R²³ and R²⁴ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Z³ is SO₃H or a salt thereof;
t is a number of 1 to 4, preferably 1 to 3, more preferably 1 to 2;
u is a number of 0 to 3, preferably 0 to 2, more preferably 0;
with the proviso that t+u is 1 to 4.

The counter cation to form a salt of the pigment derivative of formula (XII) may be a metal cation, for example, an alkali metal or ½ earth alkali metal cation, ammonium or substituted ammonium. Examples of substituted ammonium cations are ⁺N(CH₃)₂(C₁₈H₃₇)₂, ⁺NH(CH₃)₂(C₁₈H₃₇), ⁺N(CH₃)₂(C₁₂H₂₅)₂, ⁺NH(CH₃)2(C₁₂H₂₅), ⁺N(CH₃)₂(C₁₀H₂₁)₂, ⁺NH(CH₃)₂(C₁₀H₂₁), ⁺N(CH₃)₂(C₈H₁₇)₂, ⁺NH(CH₃)₂(C₈H₁₇), ⁺NH(C₈H₁₇)₃, ⁺NH(C₁₀H₂₁)₃, ⁺NH(C₁₂H₂₅)₃ and ⁺NH(C₁₈H₃₅)₃.

Usually the pigment derivatives of formula (XII) consist of a mixture with different degrees of substitution, so that the numbers t, u, and t+u may also take on fractional numerical values. Said numerical values may also be less than 1; consequently, a pigment preparation may in fact come about during the preparation of the pigment derivative.

More preferred is a pigment derivative of formula (XII), wherein
X¹ is a group of formula

   -A¹-D-G (III)

   ;
A¹ is a direct bond;
D is -CO-NR⁵- or -SO₂-NR⁵-, preferably -SO₂-NR⁵-;
Ar⁶ is at each occurrence selected from 1,4-phenylene; 1,4-phenylene substituted with Cl, CH₃, OCH₃; or pyridine-2,5-diyl, preferably 1,4-phenylene; and
Ar⁷ is at each occurrence selected from phenyl; phenyl p-substituted with Cl, CH₃ or OCH₃; 2-benzothiazole or 6-methyl-2-benzothiazole, preferably phenyl or phenyl p-substituted with Cl, CH₃ or OCH₃.

Most preferred is a pigment derivative of formula (XII), wherein both groups of Ar⁶ are the same, and both groups of Ar⁷ are the same.

Especially, Ar⁷ is p-substituted with X¹, and u is 0.

Especially preferred is a pigment composition comprising
(a) a pigment of formula (I), and
(b) a pigment derivative of formula (XII), wherein
Ar¹ and Ar⁶ are the same, and Ar² and Ar⁷ are the same.

Further preferred is a pigment derivative of formula 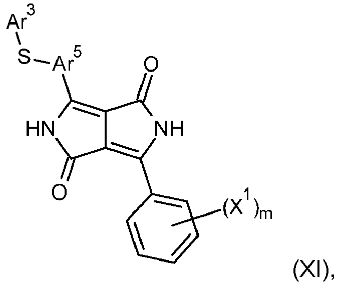 wherein
m is 1 or 2, preferably 1;
X¹ is a group comprising an aliphatic carboxamide group or an aliphatic sulfonamide group, preferably the group of formula

   -A¹-D-G (III)

   ;
Ar³ is C₆-C₁₀-aryl or C₂-C₆-heteroaryl, said aryl or heteroaryl is unsubstituted or substituted with R¹⁰ and/or R¹¹;
R¹⁰ and R¹¹ are independently of one another Cl, Br, C₁-C₄-alkyl, OC₁-C₄-alkyl, CF₃ or CN; or
R¹⁰ and R¹¹ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Ar⁵ is phenylene or C₂-C₆-heteroarylene, said phenylene or heteroarylene is unsubstituted or substituted with R²¹; and
R²¹ is Cl, Br, C₁-C₄-alkyl, OC₁-C₄-alkyl, CF₃ or CN.

The group X¹, preferably the group of formula

-A¹-D-G (III)

, may be in meta or para position, preferably in meta position.

Accordingly, further preferred is a pigment derivative of formula 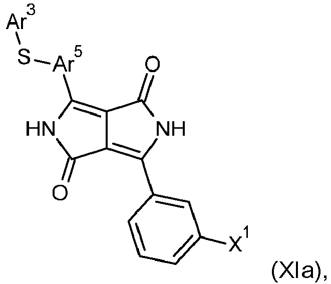 wherein
X¹ is a group of formula

   -A¹-D-G (III)

   ,
A¹ is a direct bond or methylene, preferably, a direct bond;
D is -NHCO-, -CO-NR⁵- or -SO₂-NR⁵-, preferably -CO-NR⁵- or -SO₂-NR⁵-;
G is -(C₁-C₄-alkylene)-NR⁶R⁷, said C₁-C₄-alkylene may be interrupted by -NH-;
R⁵ is H;
or G and R⁵ together with the linking nitrogen form a 6-membered ring, said 6-membered ring may be substituted by C₁-C₄-alkyl and/or interrupted by NR⁸, O or S; R⁶ and R⁷ are independently of one another H or C₁-C₄-alkyl;
or R⁶ and R⁷ together with the linking nitrogen form a 5- or 6-membered ring, said ring may be substituted by C₁-C₄-alkyl and/or interrupted by NR⁸, O or S;
R⁸ is H or C₁-C₄-alkyl;
Ar³ is C₆-C₁₀-aryl or C₂-C₆-heteroaryl, said aryl or heteroaryl is unsubstituted or substituted with R¹⁰ and/or R¹¹;
R¹⁰ and R¹¹ are independently of one another Cl, Br, C₁-C₄-alkyl, OC₁-C₄-alkyl, CF₃ or CN; or
R¹⁰ and R¹¹ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Ar⁵ is 1-4-phenylene or C₂-C₆-heteroarylene, said phenylene or heteroarylene is unsubstituted or substituted with R²¹; and
R²¹ is Cl, Br, C₁-C₄-alkyl, OC₁-C₄-alkyl, CF₃ or CN.

More preferred is a pigment derivative of formula (XIa), wherein
Ar⁵ is 1,4-phenylene; 1,4-phenylene substituted with Cl, CH₃, OCH₃; or pyridine-2,5-diyl, preferably 1,4-phenylene; and
Ar³ is phenyl; phenyl p-substituted with Cl, CH₃ or OCH₃; 2-benzothiazole or 6-methyl-2-benzothiazole, preferably phenyl or phenyl p-substituted with Cl, CH₃ or OCH₃.

Especially preferred is a pigment derivative of formula 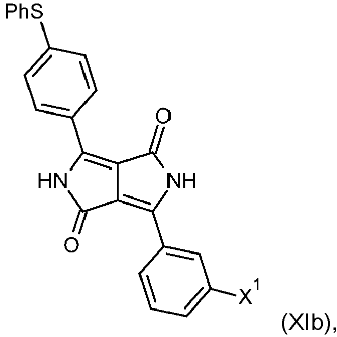 wherein
A¹ is a direct bond or methylene, preferably a direct bond;
D is -NHCO-, -CO-NR⁵- or -SO₂-NR⁵-, preferably -CO-NR⁵- or -SO₂-NR⁵-;
G is -(C₁-C₄-alkylene) - NR⁶R⁷, said C₁-C₄-alkylene may be interrupted by -NH-;
R⁵ is H;
R⁶ and R⁷ are independently of one another H or C₁-C₄-alkyl;
or R⁶ and R⁷ together with the linking nitrogen form a 5- or 6-membered ring, said ring may be substituted by C₁-C₄-alkyl and/or interrupted by NR⁸, O or S; and
R⁸ is H or C₁-C₄-alkyl.

Suitable Examples of a pigment derivative of formula (Xla) or (Xlb) are compounds, wherein the group -A¹-D-G is selected from -SO₂NH(CH₂)₃N(CH₃)₂, -SO₂NH(CH₂)₃N(C₂H₅)₂, -CONH(CH₂)₃N(CH₃)₂, -SO₂NH(CH₂)₃N(nC₄H₉)₂, -CONH(CH₂)₃N(C₂H₅)₂,
-CONH(CH₂)₃N(nC₄H₉)₂,

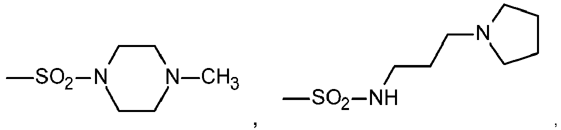

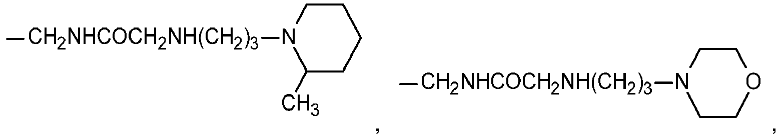

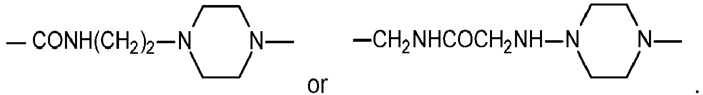

Especially preferred is a pigment composition comprising
(a) a pigment of formula (I), and
(b) a pigment derivative of formula (XIa), wherein
   Ar¹ and Ar³ are the same, and Ar² and Ar⁵ are the same; and
   Ar¹ is 1,4-phenylene; 1,4-phenylene substituted with Cl, CH₃, OCH₃; or pyridine-2,5-diyl, preferably 1,4-phenylene; and
   Ar² is phenyl; phenyl p-substituted with Cl, CH₃ or OCH₃; 2-benzothiazole or 6-methyl-2-benzothiazole, preferably phenyl or phenyl p-substituted with Cl, CH₃ or OCH₃.

Suitable examples of pigment derivatives of formula (IIa) or (IIb) are those as described, for example, in JP-A-2000-273346, JP-A-H03-26767, EP-A-2495288 or as colorant (V) in WO-A-09/144115. The pigment derivatives may be prepared by known methods in the art, for example, in analogy to methods described in JP-A-2000-273346, JP-A-H03-26767 or as colorant (V) in WO-A-09/144115. For example, an asymmetric diketopyrrolopyrrole may be prepared via 4-ethoxycarbonyl-5-phenylpyrrolid-2-one, which may be prepared in accordance with C. Morton et al, Tetrahedron 2002, 58, 5547-5565, wherein various substituents may be introduced. These may then be replaced or further reacted by conventional methods known in the art.

There are several synthesizing routes for preparing the diketopyrrolopyrrole pigment derivatives of formula (XII). For example, a pigment of formula (I) may be reacted with fuming sulfuric acid for sulfonation to produce a sulfonated pigment derivative, followed by reacting the sulfonated pigment derivative with a chlorinating agent to prepare a chlorosulfonated pigment derivative. Then, the chlorosulfonated pigment derivative is reacted with a suitable amine compound to obtain a sulfonamide-substituted pigment derivative, for example, as described in EP-A-2495288. Likewise, the pigment derivative of formula (XII) may be reacted with chlorosulfuric acid, followed by reacting with a suitable amine compound and, if desired, reacting the free sulfonic acid with an ammonium salt or metal salt, as described, for example, in WO-A-02/064680. Similarly, the pigment derivatives of formula (XII) may be prepared by conventional chloromethylation, followed by reacting with a suitable amine compound, as described, for example, in JP-A-2000-273346.

A further preferred pigment derivative of formula (II) is a quinacridone derivative of formula 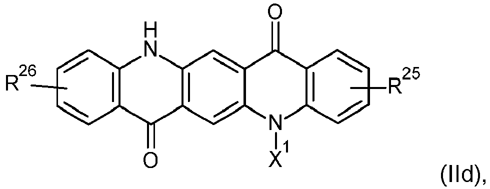 wherein R25 and R²⁶ are independently of one another H, halogen or C₁-C₄-alkyl, and X¹ is a group of formula

-A²-E (IV)

.

A suitable pigment derivative of formula (IId) is, for example, a pigment derivative of formula 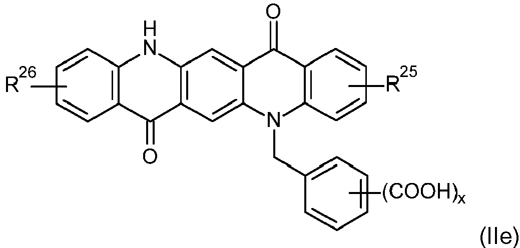 or a salt thereof, wherein x is 1, 2 or 3, preferably 2.

The counter cation to form a salt of the pigment derivative of formula (IIe) may be a metal cation, for example, an alkali metal or ½ earth alkali metal cation, ammonium or substituted ammonium. Examples of substituted ammonium cations are ⁺N(CH₃)₂(C₁₈H₃₇)₂, ⁺NH(CH₃)₂(C₁₈H₃₇), ⁺N(CH₃)₂(C₁₂H₂₅)₂, ⁺NH(CH₃)₂(C₁₂H₂₅), ⁺N(CH₃)₂(C₁₀H₂₁)₂, ⁺NH(CH₃)₂(C₁₀H₂₁), ⁺N(CH₃)₂(C₈H₁₇)₂, ⁺NH(CH₃)₂(C₈H₁₇), ⁺NH(C₈H₁₇)₃, ⁺NH(C₁₀H₂₁)₃, ⁺NH(C₁₂H₂₅)₃ and ⁺NH(C₁₈H₃₅)₃.

Suitable examples of pigment derivatives of formula (IId) are those described in WO-A-2007/060254 or WO-A-2007/060259.

The pigment composition may contain one or more pigment derivatives of formulae (II) and/or (XII), especially one or more pigment derivatives of formulae (IIa) and/or (XII). It is also preferred that the pigment composition contains a pigment derivative of formula (IIa) in combination with a pigment derivative of formula (IId). In particular, the pigment composition contains a pigment derivative of formula (IIa) or (XI).

The pigment composition may further comprise (c) a pigment derivative, which is different from the pigment derivative of formula (II).

Accordingly, in a preferred aspect, the pigment composition comprises
(c) a pigment derivative of formula

   (P²) - (Y)ₙ (V)

   , wherein
P² is a residue of a colorant chromophore; and
Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene;
R¹⁴ is H or C₁-C₄-alkyl; and
n is 1, 2, 3 or 4, preferably 1 or 2.

The pigment derivative of formula (P²) - (Y)ₙ (V) is preferred, wherein P² is a residue of a colorant chromophore selected from the group consisting of a diketopyrrolopyrrole, a quinacridone, a dihydroquinacridone, a quinacridonequinone, an aminoanthraquinone and a perylene, preferably selected from the group consisting of a 3,6-diphenyl-2,5-dihydropyrrolo[3,4-c]pyrrole-1,4-dione, a quinacridone, a 6,13-dihydroquinacridone, a quinacridonequinone, a 4,4'-diamino-1,1'-bisanthraquinone, a perylenetetracarboxylic acid dianhydride and a perylenetetracarboxylic acid diimide. The chromophore may be unsubstituted or substituted. Suitable substituents are the same as defined for P¹.

Preferably, P² is a residue of a 3,6-diphenyl-2,5-dihydropyrrolo[3,4-c]pyrrole-1,4-dione, a quinacridone, a 6,13-dihydroquinacridone or a 4,4'-diamino-1,1'-bisanthraquinone chromophore, more preferably a residue a 3,6-diphenyl-2,5-dihydropyrrolo[3,4-c]pyrrole-1,4-dione, which is unsubstituted or substituted, preferably unsubstituted or substituted by Cl, Br, methyl, ethyl, propyl, iso-propyl, n-butyl, t-butyl, phenyl, OAr⁴ or SAr⁴, more preferably unsubstituted or substituted by CI, Br, methyl, ethyl, t-butyl, phenyl, phenoxy or S-phenyl.

The group Y preferably comprises a group of at least 8 carbon atoms, for example, OC₈-C₂₂-alkyl, SC₈-C₂₂-alkyl, OC₁₂-C₂₂-aralkyl, SC₁₂-C₂₂-aralkyl, OC₁₂-C₂₂-alkylaryl, SC₁₂-C₂₂-alkylaryl or NR¹²R¹³, wherein
R¹² and R¹³ are independently of one another H, C₈-C₂₂-alkyl, C₁₂-C₂₂-aralkyl, or C₁₂-C₂₂-alkylaryl; and
each alkyl group in Y may be interrupted by O, S, NR¹⁴ or phenylene, preferably phenylene; and
R¹⁴ is H or C₁-C₄-alkyl, preferably H or CH₃.

The group Y may be present up to 4 times, preferably once or twice, i.e. n is 1 or 2. Preferably, each Y may be the same or may be different, preferably, each Y is the same.

In a preferred aspect, the pigment derivative of formula (V) is a diketopyrrolopyrrole derivative of formula 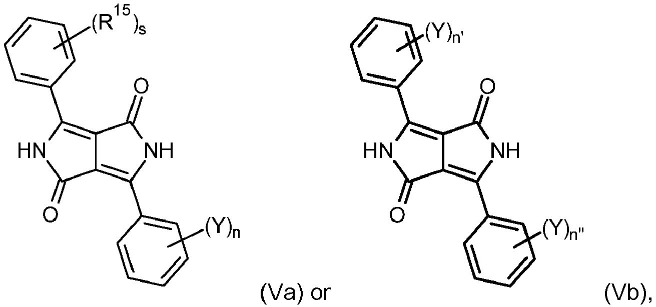 wherein
n is 1 or 2, preferably 1;
n' and n" are independently of one another 1 or 2;
s is 0, 1 or 2, preferably 0 or 1; and
R¹⁵ is at each occurrence selected from Cl, Br, CF₃, CN, C₁-C₄-alkyl, OC₁-C₄-alkyl, SC₁-C₄-alkyl, Ar⁴, OAr⁴ or SAr⁴;
Ar⁴ is C₆-C₁₀-aryl or C₂-C₆-heteroaryl, said aryl or heteroaryl is unsubstituted or substituted with R¹⁶ and/or R¹⁷;
R¹⁶ and R¹⁷ are independently of one another Cl, Br, C₁-C₄-alkyl, OC₁-C₄-alkyl, CF₃ or CN; or
R¹⁶ and R¹⁷ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Y is OC₈-C₂₂-alkyl, SC₈-C₂₂-alkyl, OC₁₂-C₂₂-aralkyl, SC₁₂-C₂₂-aralkyl, OC₁₂-C₂₂-alkylaryl, SC₁₂-C₂₂-alkylaryl or NR¹²R¹³, wherein
R¹² and R¹³ are independently of one another H, C₈-C₂₂-alkyl, C₁₂-C₂₂-aralkyl, or C₁₂-C₂₂-alkylaryl; and
each alkyl group in Y may be interrupted by O, S, NR¹⁴ or phenylene, preferably phenylene; and
R¹⁴ is H or C₁-C₄-alkyl, preferably H or CH₃.

In a further preferred aspect, the pigment derivative of formula

(P²) - (Y)ₙ (V)

is a diketopyrrolopyrrole derivative of formula 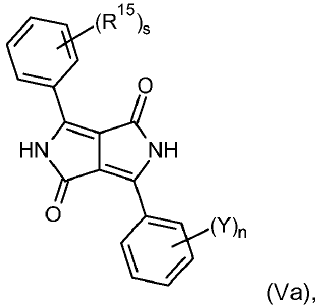 wherein
n is 1;
s is 0, 1 or 2, preferably 0 or 1;
R¹⁵ is at each occurrence Cl, Br, CF₃, CN, C₁-C₄-alkyl, OC₁-C₄-alkyl, SC₁-C₄alkyl, Ar⁴, OAr⁴ or SAr⁴;
Ar⁴ is C₆-C₁₀-aryl or C₂-C₆-heteroaryl, said aryl or heteroaryl is unsubstituted or substituted with R¹⁶ and/or R¹⁷;
R¹⁶ and R¹⁷ are independently of one another Cl, Br, C₁-C₄-alkyl, OC₁-C₄-alkyl, CF₃ or CN; or
R¹⁶ and R¹⁷ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Y is selected from OC₈-C₂₂-alkyl, SC₈-C₂₂-alkyl, OC₁₂-C₂₂-aralkyl, SC₁₂-C₂₂-aralkyl, OC₁₂-C₂₂-alkylaryl, SC₁₂-C₂₂-alkylaryl or NR¹²R¹³,
R¹² and R¹³ are independently of one another H, C₈-C₂₂-alkyl, C₁₂-C₂₂-aralkyl, or C₁₂-C₂₂-alkylaryl;
each alkyl group in Y may be interrupted by O, S, NR¹⁴ or phenylene; and R¹⁴ is H or C₁-C₄-alkyl.

More preferred is a pigment derivative of formula (Va), wherein
n is 1;
s is 1;
R¹⁵ is p-substituted, especially p-substituted with R⁹ being Cl, Br, Me, OMe, phenyl, phenoxy or SAr⁴; and
Ar⁴ is phenyl; phenyl which is p-substituted with Cl, CH₃ or OCH₃; 2-benzothiazole or 6-methyl-2-benzothiazole, preferably phenyl or phenyl which is p-substituted with Cl, CH₃ or OCH₃.

Further preferred is a pigment derivative of formula 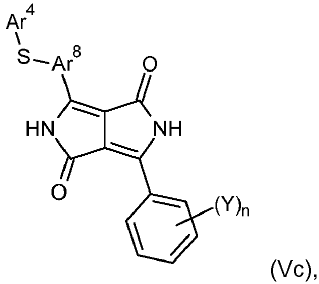 where
n is 1 or 2, preferably 1;
Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene;
R¹⁴ is H or C₁-C₄-alkyl;
Ar⁸ is phenylene or C₂-C₆-heteroarylene, said phenylene or heteroarylene is unsubstituted or substituted with R²⁷; and
R²⁷ is Cl, Br, C₁-C₄-alkyl, OC₁-C₄-alkyl, CF₃ or CN;
Ar⁴ is C₆-C₁₀-aryl or C₂-C₆-heteroaryl, said aryl or heteroaryl is unsubstituted or substituted with R¹⁶ and/or R¹⁷;
R¹⁶ and R¹⁷ are independently of one another Cl, Br, C₁-C₄-alkyl, OC₁-C₄-alkyl, CF₃ or CN; or
R¹⁶ and R¹⁷ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl.

The group Y may be in meta or para position, preferably in para position.

In particular, the group Y comprises linear alkyl groups.

Accordingly, further preferred is a pigment derivative of formula 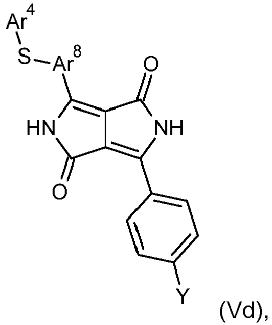 wherein
Y is OC₈-C₂₂-alkyl, SC₈-C₂₂-alkyl, OC₁₂-C₂₂-aralkyl, SC₁₂-C₂₂-aralkyl, OC₁₂-C₂₂-alkylaryl, SC₁₂-C₂₂-alkylaryl or NR¹²R¹³;
R¹² and R¹³ are independently of one another H, C₈-C₂₂-alkyl, C₁₂-C₂₂-aralkyl, or C₁₂-C₂₂-alkylaryl; and
each alkyl group in Y may be interrupted by O, S, NR¹⁴ or phenylene, preferably phenylene; and
R¹⁴ is H or C₁-C₄-alkyl, preferably H or CH₃;
Ar⁸ is phenylene or C₂-C₆-heteroarylene, said phenylene or heteroarylene is unsubstituted or substituted with R²⁷;
R²⁷ is Cl, Br, C₁-C₄-alkyl, OC₁-C₄-alkyl, CF₃ or CN;
Ar⁴ is C₆-C₁₀-aryl or C₂-C₆-heteroaryl, said aryl or heteroaryl is unsubstituted or substituted with R¹⁶ and/or R¹⁷;
R¹⁶ and R¹⁷ are independently of one another Cl, Br, C₁-C₄-alkyl, OC₁-C₄-alkyl, CF₃ or CN; or
R¹⁶ and R¹⁷ together with the aryl or heteroaryl ring to which they are bonded form an aromatic or heteroaromatic ring, said aromatic or heteroaromatic ring is unsubstituted or substituted with Cl or C₁-C₄-alkyl.

More preferred is a pigment derivative of formula (Vc) or of formula (Vd), wherein
Ar⁸ is 1,4-phenylene; 1,4-phenylene substituted with Cl, CH₃, OCH₃; or pyridine-2,5-diyl, preferably 1,4-phenylene; and
Ar⁴ is phenyl; phenyl p-substituted with Cl, CH₃ or OCH₃; 2-benzothiazole or 6-methyl-2-benzothiazole, preferably phenyl or phenyl p-substituted with Cl, CH₃ or OCH₃.

Especially preferred is a pigment derivative of formula 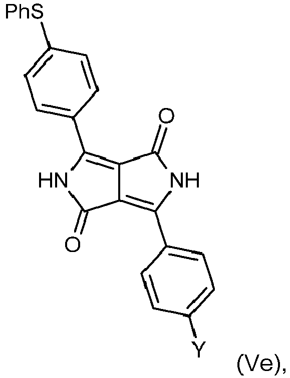 wherein
Y is OC₈-C₂₂-alkyl, SC₈-C₂₂-alkyl, OC₁₂-C₂₂-aralkyl, SC₁₂-C₂₂-aralkyl, OC₁₂-C₂₂-alkylaryl or SC₁₂-C₂₂-alkylaryl,
each alkyl group in Y may be interrupted by O, S, NR¹⁴ or phenylene, preferably phenylene; and
R¹⁴ is H or C₁-C₄-alkyl, preferably H or CH₃.

Suitable examples of pigment derivatives of formula (V) are those described in WO-A-2005/040283.

A particular preferred pigment composition comprises
a) a pigment of formula (I), wherein
   Ar¹ is at each occurrence selected from 1,4-phenylene or C₃-C₅-heteroarylene, said phenylene is unsubstituted or substituted with R¹;
   Ar² is at each occurrence selected from phenyl or heteroaryl, said phenyl or heteroaryl is unsubstituted or substituted with R² and/or R³;
   R¹ is Cl, CH₃ or OCH₃;
   R² and R³ are independently of one another Cl, CH₃ or OCH₃; or
   R² and R³ together with the aryl or heteroaryl ring to which they are bonded form an aromatic or heteroaromatic 5- or 6-membered ring; and
b) a pigment derivative of formula (XI), preferably of formula (XIa), wherein
   m is 1 or 2, preferably 1;
   X¹ is a group of formula

      -A¹-D-G (III)

      ;
   A¹ is a direct bond or methylene, preferably, a direct bond;
   D is -NHCO-, -CO-NR⁵- or -SO₂-NR⁵-, preferably -CO-NR⁵- or -SO₂-NR⁵-;
   G is -(C₁-C₄-alkylene)-NR⁶R⁷, said C₁-C₄-alkylene may be interrupted by -NH-;
   R⁵ is H;
   or G and R⁵ together with the linking nitrogen form a 6-membered ring, said 6-membered ring may be substituted by C₁-C₄-alkyl and/or interrupted by NR⁸, O or S; R⁶ and R⁷ are independently of one another H or C₁-C₄-alkyl;
   or R⁶ and R⁷ together with the linking nitrogen form a 5- or 6-membered ring, said ring may be substituted by C₁-C₄-alkyl and/or interrupted by NR⁸, O or S;
   R⁸ is H or C₁-C₄-alkyl;
   Ar³ is C₆-C₁₀-aryl or C₂-C₆-heteroaryl, said aryl or heteroaryl is unsubstituted or substituted with R¹⁰ and/or R¹¹;
   R¹⁰ and R¹¹ are independently of one another Cl, Br, C₁-C₄-alkyl, OC₁-C₄-alkyl, CF₃ or CN; or
   R¹⁰ and R¹¹ together with the aryl or heteroaryl ring to which they are bonded form an aromatic or heteroaromatic ring, said aromatic or heteroaromatic ring is unsubstituted or substituted with Cl or C₁-C₄-alkyl;
   Ar⁵ is phenylene or C₂-C₆-heteroarylene, said phenylene or heteroarylene is unsubstituted or substituted with R²¹; and
   R²¹ is Cl, Br, C₁-C₄-alkyl, OC₁-C₄-alkyl, CF₃ or CN; and
c) optionally a pigment derivative of formula (Vc), preferably of formula (Vd), wherein
   n is 1 or 2, preferably 1;
   Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
   R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene;
   R¹⁴ is H or C₁-C₄-alkyl;
   Ar⁸ is phenylene or C₂-C₆-heteroarylene, said phenylene or heteroarylene is unsubstituted or substituted with R²⁷; and
   R²⁷ is Cl, Br, C₁-C₄-alkyl, OC₁-C₄-alkyl, CF₃ or CN;
   Ar⁴ is C₆-C₁₀-aryl or C₂-C₆-heteroaryl, said aryl or heteroaryl is unsubstituted or substituted with R¹⁶ and/or R¹⁷;
   R¹⁶ and R¹⁷ are independently of one another Cl, Br, C₁-C₄-alkyl, OC₁-C₄-alkyl, CF₃ or CN; or
   R¹⁶ and R¹⁷ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl.

Especially preferred is a pigment composition comprising
(a) a pigment of formula (I), and
(b) a pigment derivative of formula (Xla), preferably of formula (Xlb), and
(c) optionally a pigment derivative of formula (Vc), preferably of formula (Vd), wherein
   Ar¹, Ar³ and Ar⁴ are the same, and Ar², Ar⁵ and Ar⁸ are the same; and
   Ar¹ is 1,4-phenylene; 1,4-phenylene substituted with Cl, CH₃, OCH₃; or pyridine-2,5-diyl; preferably 1,4-phenylene; and
   Ar² is phenyl; phenyl p-substituted with Cl, CH₃ or OCH₃; 2-benzothiazole or 6-methyl-2-benzothiazole; preferably phenyl or phenyl p-substituted with Cl, CH₃ or OCH₃.

The pigment composition of the invention usually comprises pigment (a) in an amount of at least 65 wt%, based on the total weight of the pigment composition, preferably 70 to 80 wt%.

The pigment composition of the invention usually comprises the pigment derivative (b) of formula (II) in an amount of about 3 to 35 wt%, based on the total weight of the pigment composition, preferably 5 to 20 wt%.

If present, the pigment composition of the invention may comprise the pigment derivative (c) of formula (V) in an amount of about 0.1 to 10 wt%, based on the total weight of the pigment composition, preferably 0.5 to 7 wt%, more preferably 0.5 to 5 wt%.

Preferably, the pigment composition of the invention comprises pigment (a) in an amount of 70-80 wt%, the pigment derivative (b) of formula (II) in an amount of 5-20 wt%, and, if present, the pigment derivative (c) of formula (V) in an amount of 0.5 to 7 wt%, based on the total weight of the pigment composition.

The pigment composition may further comprise a pigment derivative (d), which is different from the pigment derivative of formula (II) and the pigment derivative of formula (V).

Accordingly, in a preferred aspect, the pigment composition further comprises (d) a pigment derivative of formula

(Z²)ₚ - (P³) - (A³- Z¹)_{q} (VI)

, wherein
P³ is a residue of a colorant chromophore,
A³ is C₁-C₆-alkylene;
Z¹ is a N-containing 5-membered heterocycle, preferably a heteroaromatic ring; and
Z² is SO₃H or a salt thereof, or CO₂H or a salt thereof,
p is a number of 0 to 2; and
q is a number of 1 or 2.

The pigment derivative of formula

(Z²)ₚ - (P³) - (A³- Z¹)_{q} (VI)

is preferred, wherein P³ is a residue of a colorant chromophore selected from the group consisting of a diketopyrrolopyrrole, a quinacridone, a dihydroquinacridone, a quinacridonequinone, an aminoanthraquinone and a perylene, preferably selected from the group consisting of a 3,6-diphenyl-2,5-dihydropyrrolo[3,4-c]pyrrole-1,4-dione, a quinacridone, a 6,13-dihydroquinacridone, a quinacridonequinone, a 4,4'-diamino-1,1'-bisanthraquinone, a perylenetetracarboxylic acid dianhydride and a perylenetetracarboxylic acid diimide. The chromophore may be unsubstituted or substituted. Suitable substituents are the same as defined for P¹.

Preferably, P³ is a residue of a 3,6-diphenyl-2,5-dihydropyrrolo[3,4-c]pyrrole-1,4-dione, a quinacridone or a 4,4'-diamino-1,1'-bisanthraquinone chromophore, which chromophores are unsubstituted or substituted, more preferably a residue of a 3,6-diphenyl-2,5-dihydropyrrolo[3,4-c]pyrrole-1,4-dione or a quinacridone.

Preferably, P³ is a residue of a diketopyrrolopyrrole or a quinacridone chromophore.

The group Z¹ is a N-containing 5-membered heterocycle having 1, 2 or 3 nitrogen atoms, preferably a heteroaromatic ring.

Accordingly, in a preferred aspect the pigment composition comprises a pigment derivative (d) of formula

(Z²)ₚ - (P³) - (A³- Z¹)_{q} (VI)

, wherein Z¹ is a group selected from the group consisting of 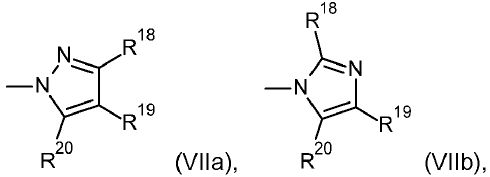 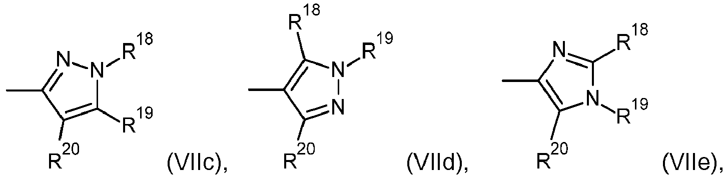 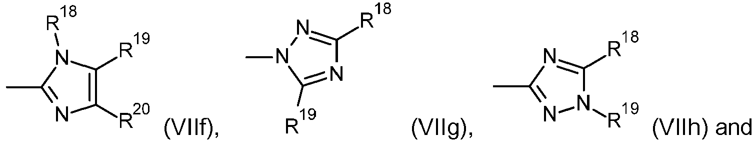 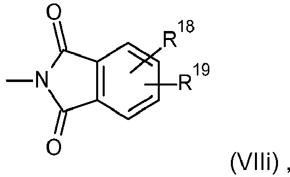 wherein
R¹⁸, R¹⁹ and R²⁰ are independently of one another and at each occurrence selected from H, halogen, C₁-C₁₈-alkyl; C₁-C₁₈-alkyl substituted with halogen, OC₁-C₆-alkyl or di(C₁-C₆-alkyl)amino; C₆-C₁₂-aryl; or C₆-C₁₂-aryl substituted with or C₁-C₁₈-alkyl, halogen, nitro or OC₁-C₆-alkyl;
two adjacent groups of R¹⁸, R¹⁹ and R²⁰ together with the heteroaryl ring to which they are bonded form a 5- to 7-membered alicyclic, aromatic or heteroaromatic ring, preferably a 5- to 6-membered alicyclic, aromatic or heteroaromatic ring.

Preferred is a pigment derivative (d), wherein Z¹ is a group of formula (VIIa), (VIId), (Vile) and/or (VIIi). More preferably, the group Z¹ is a group of formula (Vile) or (VIIi).

Preferably, R¹⁸, R¹⁹ and R²⁰ are independently of one another and at each occurrence selected from H, Cl, C₁-C₄-alkyl; C₁-C₄-alkyl substituted with Cl, OMe, OEt or di(C₁-C₄-alkyl)amino; C₆-C₁₂-aryl; or C₆-C₁₂-aryl substituted with or C₁-C₄-alkyl, Cl, nitro or OMe or OEt;
two adjacent groups of R¹⁸, R¹⁹ and R²⁰ together with the heteroaryl ring to which they are bonded form a 5- to 6-membered alicyclic, aromatic or heteroaromatic ring, preferably a benzoannelated ring.

If Z² is a salt of a sulfonic acid group or carboxylic acid group, a suitable counter cation may be a metal cation, for example, an alkali metal or ½ earth alkali metal cation, ammonium or substituted ammonium. Examples of substituted ammonium cations are ⁺N(CH₃)₂(C₁₈H₃₇)₂, ⁺NH(CH₃)₂(C₁₈H₃₇), ⁺N(CH₃)₂(C₁₂H₂₅)₂, ⁺NH(CH₃)₂(C₁₂H₂₅), ⁺N(CH₃)₂(C,₀H₂₁)₂, ⁺NH(CH₃)₂(C₁₀H₂₁), ⁺N(CH₃)₂(C₈H₁₇)₂, ⁺NH(CH₃)₂(C₈H₁₇), ⁺NH(C₈H₁₇)₃, ⁺NH(C₁₀H₂₁)₃, ⁺NH(C₁₂H₂₅)₃ and ⁺NH(C₁₈H₃₅)₃.

Z² is preferably a sulfonic acid group or a salt thereof.

The pigment composition of the invention may comprise the pigment derivative (d) of formula (VI) in an amount of about 3 to 30 wt%, based on the total weight of the pigment composition, preferably 5 to 20 wt%.

The pigment composition may be prepared by mixing component (a), component (b) and optionally component (c) and component (d). Alternatively, the pigment composition may be prepared during synthesis of pigment of formula (I), provided that pigment derivative (b) and optional pigment derivative (c) are derived from a residue of a diketopyrrolopyrrole chromophore, herein designated as mixed synthesis.

The pigment derivative (b) of formula (II) may be added during synthesis of the pigment of formula (I) and/or may be blended as a pigment synergist with pigment (a) of formula (I) and/or may be added as a pigment synergist during manufacturing the pigment dispersion. In case that pigment derivative (b) of formula (II) is added during synthesis of pigment (a) of formula (I) the amount of pigment derivative (b) of formula (II) is of from 3 to 12 wt%, preferably from 5 to 9 wt%.

Alternatively, pigment derivative (b) of formula (II) may be prepared during the synthesis of pigment of formula (I), provided that pigment derivative (b) is derived from a residue of a diketopyrrolopyrrole chromophore.

The pigment derivative (c) of formula (V) may be added during synthesis of the pigment of formula (I) in an amount of from 0.1 to 10 wt%, preferably 0.5 to 7 wt%, more preferably 0.5 to 5 wt%.

Alternatively, pigment derivative (c) of formula (V) may be prepared during the synthesis of pigment of formula (I), provided that pigment derivative (c) is derived from a residue of a diketopyrrolopyrrole chromophore.

The pigment derivative (d) of formula (VI) may be added during synthesis of the pigment of formula (I) and/or may be dry-blended as a pigment synergist with pigment of formula (a) and/or may be added as a pigment synergist during manufacturing the pigment dispersion.

It is preferred that pigment derivative (b) and (c), if present, are prepared during the synthesis of pigment of formula (I).

Thus, in a further aspect the invention relates to a process for preparing a pigment composition, as defined in any aspect herein, wherein P¹ and P² are a residue of a diketopyrrolopyrrole chromophore,
which process comprises reacting a succinic diester with a compound of formula

NC - Ar¹ - S - Ar² (VIII)

, a compound of formula 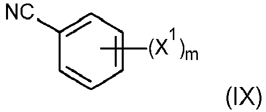 and optionally a compound of formula 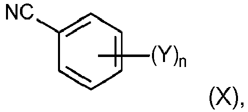 wherein
Ar¹ is phenylene or C₂-C₆-heteroarylene, said phenylene or heteroarylene is unsubstituted or substituted with R¹;
Ar² is C₆-C₁₀-aryl or C₂-C₆-heteroaryl, said aryl or heteroaryl is unsubstituted or substituted with R² and/or R³;
R¹ is Cl, Br, C₁-C₄-alkyl, OC₁-C₄-alkyl, CF₃ or CN;
R² and R³ are independently of one another Cl, Br, C₁-C₄-alkyl, OC₁-C₄-alkyl, CF₃ or CN; or
R² and R³ together with the aryl or heteroaryl ring to which they are bonded form an aromatic or heteroaromatic ring, said aromatic or heteroaromatic ring is unsubstituted or substituted with R⁴,
R⁴ is Cl or C₁-C₄-alkyl;
m is 1 or 2, preferably 1;
n is 1 or 2, preferably 1;
X¹ is a group comprising an aliphatic carboxamide group or an aliphatic sulfonamide group;
Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene; and R¹⁴ is H or C₁-C₄-alkyl.

The synthesis of diketopyrrolopyrrole pigments is known to one skilled in the art. The DPP colorants may be synthesized, for example, in accordance with the reaction schemes and processes disclosed in Bull. Soc. Chim. Belg. 97(8-9), 1988, 615, EP-A-0061426, EP-A-0094911, EP-A-0098808, EP-A-0184982, EP-A-0232222 or EP-A-0302018.

The reaction is generally performed by reacting 1 mol of a succinic diester with about 1.7 to 1.95 equivalents of nitriles of formulae (VIII) and (IX) and optionally (X), especially 1.75 and 1.9 equivalents, in an organic solvent and in the presence of a base at elevated temperature to form a pigment alkali metal salt, followed by hydrolysis of the pigment alkali metal salt in water and/or alcohol and optionally acid.

The mixture obtained after hydrolysis is usually treated at a specific temperature (ripening temperature, for example, between -15°C to 50°C, preferably -10°C to 40°C) for some hours, for example between 10 and 30 hours, preferably 15 to 25 hours, to obtain the pigment composition.

The amount of the nitrile of formula (VIII) may be in the range of about 0.85 to about 0.99 mol%, based on the total amount of nitriles used in the synthesis, preferably about 0.87 to about 0.99 mol%. The amount of the nitrile of formula (IX) may be in the range of about 0.01 to about 0.15 mol%, based on the total amount of nitriles used in the synthesis, preferably about 0.01 to 0.13 mol%. If present, the amount of the nitrile of formula (X) may be in the range of about 0.01 to about 0.10 mol%, based on the total amount of nitriles used in the synthesis, preferably about 0.01 to about 0.08 mol%.

Optionally, the process may be performed in the presence of the pigment derivative (d) of formula (Z²)ₚ - (P³) - (A³- Z¹)_{q} (VI), as defined herein-before.

In case the pigment derivative (d) is added during the synthesis reaction the amount may be in the range of about 0.01 to about 0.3 wt%, based on the theoretical weight of the pigment composition of (a) and (b) and (c), if present, obtained after synthesis.

Suitable disuccinates may be dialkyl, diaryl or monoalkyl-monoaryl-succinates, preferably dialkyl succinates like di-isopropyl succinates, di-t-butyl succinate, di-t-amyl succinates and the like. The reaction of the disuccinate with the nitriles of formulae (VIII) and (IX) and optionally (X) is usually carried out in an organic solvent, preferably in alcohols, for example, in a secondary or tertiary alcohol, like t-butyl alcohol or t-amyl alcohol. The overall concentration of the nitriles in the organic solvent is generally 0.5 to 5 mol/l. Suitable bases are in particular alkali metal alcoholate, like sodium or potassium iso-propylate, s-butylate, t-butylate or t-amylate. The base is usually prepared *in situ* by reacting the appropriate alcohol with the alkali metal, metal hydride or alkali metal amide. The base is usually used in excess of 2 mol, up to 4 mol. The reaction may be performed by a temperature in the range of 60 to 140°C, preferably of 80 to 120°C. In case the pigment derivative (b), (c) and/or (d) is/are added during synthesis, it is usually added prior to the hydrolysis. The hydrolysis of the condensation product(s) may be carried out with water, an alcohol like methanol or ethanol, or acid, like acetic acid or sulphuric acid. In the course of the hydrolysis the pigment composition of the invention precipitates and may be isolated by filtration.

In general, the alkali metal salt of the pigment of formula (I) and the alkali metal salt(s) of the pigment derivative of formulae (II) and (V), if present, are formed in the course of synthesis. The alkali metal salts are precipitated by protonation, optionally in the presence of pigment derivative (d). In the process, preference is given to adjusting the pH, by adding water, hydroxy compounds, acid salts and/or acid, to a final value of < 10, especially < 7, very especially < 5.

Preferably, one or more aromatic nitriles, which aromatic nitriles are different from a nitrile of formula (IX) and a nitrile of formula (X), more preferably one aromatic nitrile, may be included in the synthesis of pigment of formula (I). Suitable examples are benzonitrile, 4-phenyl-benzonitrile, 4-chloro-benzonitrile, 1,3- and 1,4 dicyanobenzene. The nitriles usually lead to further diketopyrrolopyrrole components functioning as additional growth inhibitors, as known in the art, for example, as described in US-A-5738719. The amount of an additional nitrile may be in the range of about 0.01 to about 0.10 mol%, based on the total amount of nitriles used in the synthesis, preferably about 0.01 to about 0.08 mol%.

The pigment composition of (a) and (b) and optional (c), obtained according to the process of the invention, has generally an average particle size of ≤ 100 nm, and preferably of from 10 to 100 nm, more preferably of from 10-80 nm, and especially from 10 to 30 nm. The pigment composition has preferably the form of platelets, for example, having an average particle height of from 2.5 to 7 nm and an average particle length of from 20 to 50 nm. The particles have generally an average aspect ratio of at least 2.5, more preferably at least 5.

The particle size is understood to be the equivalent diameter of the particles, which can be determined, for example, by means of a Joyce-Lobl disc centrifuge or by dynamic laser radiation scattering. Evaluation of transmission electron microscopy (TEM) images is also often adequate. The averaging of the particle size should be carried out on the basis of weight (that is, plotting the total weight of particles of the same equivalent diameter versus this equivalent diameter for all sizeable particles, the average particle size is the arithmetic mean of the resulting weight distribution - see "basic principles of particle size analysis" by Dr. Alan Rawle, obtainable from Malvern Instruments).

The particle size may also be adjusted by suitable means of finishing processes, for example by mechanical or chemical processes known *per se,* such as dry or wet grinding, kneading with a salt or treatment with acid (reprecipitation or "acid pasting"), base (for example, as described in EP-A-0707049) and / or polar solvents (Ostwald ripening or recrystallisation). A plurality of those processes may also be combined simultaneously or sequentially, for example, as mentioned in EP-A-1194485.

In a further aspect, the invention relates to a pigment composition, as defined herein- before, obtainable by a process, as defined herein-before.

Accordingly, the invention relates to a pigment composition comprising
(a) a pigment of formula 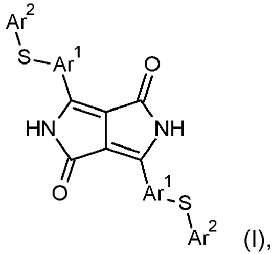 wherein
   Ar¹ is phenylene or C₂-C₆-heteroarylene, said phenylene or heteroarylene is unsubstituted or substituted with R¹;
   Ar² is C₆-C₁₀-aryl or C₂-C₆-heteroaryl, said aryl or heteroaryl is unsubstituted or substituted with R² and/or R³;
   R¹ is Cl, Br, C₁-C₄-alkyl, OC₁-C₄-alkyl, CF₃ or CN;
   R² and R³ are independently of one another Cl, Br, C₁-C₄-alkyl, OC₁-C₄-alkyl, CF₃ or CN; or
   R² and R³ together with the aryl or heteroaryl ring to which they are bonded form an aromatic or heteroaromatic 5- or 6-membered ring, said aromatic or heteroaromatic ring is unsubstituted or substituted with R⁴,
   R⁴ is Cl or C₁-C₄-alkyl; and
(b) a pigment derivative of formula

   (p1) - (X¹)ₘ (II)

   , wherein
   P¹ is a residue of a colorant chromophore,
   X¹ is a group comprising an aliphatic carboxamide group, an aliphatic sulfonamide group, a carboxylic acid group or salt thereof, and
   m is 1 or 2; and
(c) optionally a pigment derivative of formula

   (P²) - (Y)ₙ (V)

   , wherein
   P² is a residue of a diketopyrrolopyrrole chromophore; and
   Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
   R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene;
   R¹⁴ is H or C₁-C₄-alkyl; and
   n is 1 or 2;
   which pigment composition is obtainable by a process, which process comprises reacting a succinic diester with a compound of formula

   NC - Ar¹ - S - Ar² (VIII)

   , a compound of formula 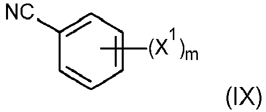 and optionally a compound of formula

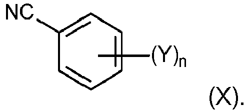

The pigment composition of the invention may be suitably dispersed with a polymeric dispersant to form a pigment dispersion.

Accordingly, in a further aspect the invention relates to a pigment dispersion comprising a pigment composition, as defined in any aspect herein, and a polymeric dispersant. It is also possible to add two or more polymeric dispersants.

Suitable polymeric dispersants improve pigment dispersion and reduce interparticulate attraction within that dispersion. The improved dispersion means a small average particle size (or particle size reduction achieved in a shorter milling time) with a narrower particle size distribution. Dispersions are significantly more stable to flocculation and agglomeration than those produced by conventional means. Suitable polymeric dispersants possess a two-component structure comprising a polymeric chain and an anchoring group. The particular combination of these leads to their effectiveness.

The polymeric dispersant may be a statistical (for example, random), alternating, gradient, graft or block copolymer. The polymeric dispersant is generally added in an amount of from 1 to 50 wt%, preferably at most 35 wt% based on pigment (a) and optionally further pigments.

Suitable polymeric dispersants copolymers are, for example, cationic copolymers, anionic copolymers, amphoteric copolymers, or non-ionic copolymers.

Copolymers can have, for example, repeating units that are derived from polymerisable or polycondensable acids, esters, glycols, nitriles, amides, imides, olefins, epoxides or aziridines, such as acrylic or methacrylic acid or their esters, amides or nitriles, terephthalic acid esters, caprolactam, ethylene, propylene, isobutylene, styrene, ethylene oxide or ethyleneimine. Preferred are graft and block copolymers.

As cationic, anionic, amphoteric or non-ionic copolymer there may be used those, for example, available under the trade name Disperbyk^{®} 111, 160, 161, 162, 163, 164, 166, 170, 171, 182, 2000, 2001, 2070, 2150, 2163; EFKA^{®} PX 4300, PX 4310, PX 4320, PX 4330, PX 4340, PX 4350, PA 4400, PA 4401, PA 4402, PA 4403, PA 4450, PX 4700, PX 4701, PX 4731, PX 4732, Dispex^{®} Ultra 4585, Solsperse^{®} 24000, 32550, Ajisper^{®} PB-821, PB-822, PB-823 and combinations thereof.

The polymeric dispersant usually affects the viscosity of the pigment dispersion. Preference is therefore given to using a polymeric dispersant which result in the pigment dispersion having a low viscosity, for example amphoteric or, especially, cationic copolymers.

The polymeric dispersants may be preferably applied to the dispersion making process. As mentioned hereinbefore, the pigment derivative (b) and the optional pigment derivative (d) may be added as a pigment synergist in the dispersion making process.

Preferably, the pigment derivative (b) is prepared during the synthesis of pigment of formula (I) and additionally added as pigment synergist by blending with the pigment of formula (I) prior to the dispersion making process.

Preferably, the pigment derivative (d) is blended as a pigment synergist with the composition of pigment of formula (I) and pigment derivative (b) and (c), if present. Alternatively, the pigment derivative (d) may be added as a pigment synergist in the dispersion making process.

During the dispersion mixing process any suitable pigment synergist other than a pigment derivative of (b) and (d) may be added to the pigment dispersion comprising the pigment composition, as defined herein. Alternatively, such a suitable pigment synergist may also be blended with the pigment composition prior to the dispersion making process. It is further possible to add such a pigment synergist in a finishing process, as mentioned herein-before.

Suitable pigment synergists may be any polar pigment derivative, preferably having acidic or basic groups. Examples may be sulfonated pigment derivatives, pigment derivatives containing a cyclic sulfonamide group, like a group of formula 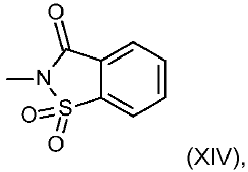 or pigment derivatives containing a phthalimide group. Suitable pigment derivatives may contain one or more groups, which groups may be the same or may be different. The pigment synergists may be derived from a residue of a colorant chromophore selected from the group consisting of a diketopyrrolopyrrole, a quinacridone, a dihydroquinacridone, a quinacridonequinone, an aminoanthraquinone, a quinophthalone and a perylene, preferably selected from the group consisting of a 3,6-diphenyl-2,5-dihydropyrrolo[3,4-c]pyrrole-1,4-dione, a quinacridone, a 6,13-dihydroquinacridone, a quinacridonequinone, a 4,4'-diamino-1,1'-bisanthraquinone, a perylenetetracarboxylic acid dianhydride, a perylenetetracarboxylic acid diimide and a N-[2-(4,5,6,7-tetrachloro-2,3-dihydro-1,3-dioxo-1H-inden-2-yl)-8-quinolyl]phthalimide (Pigment Yellow 138). Suitable examples of such pigment synergists are known in the art, as described, for example, in EP-A-1026207, US-3386843, GB-2238550, WO-A-02/10288, WO-A-02/064680 or WO-A-02/00643.

The pigment dispersion may be prepared by a variety of methods. For example, the pigment composition, a solvent and the polymeric dispersant and optionally a further pigment synergist, may be dispersed in predetermined amounts through a dispersion step. The dispersion step may be carried out using a paint conditioner, sand grinder, ball mill, roll mill, stone mill, jet mill or homogenizer. If present, further colorants may also be added. If desired, other suitable additives or a binder resin of the composition to be used for final applications may be present during dispersion step. The binder resin may be added partially or completely. Dispersion time may be suitably adjusted corresponding to the equipment used. Dispersion temperature can be varied, for example from 0°C or more, at room temperature or up to 100 °C.

The pigment composition or the pigment dispersion of the invention may be used in various applications, for example for coloring any organic material of natural or synthetic origin, for example, a photosensitive resist formulation for manufacturing a color filter, a printing ink, a liquid ink, a coating composition, a paint, plastics, a film or a fiber.

Accordingly, in a further aspect the invention relates to the use of a pigment composition, as defined in any aspect herein, for coloring a photosensitive resist formulation for manufacturing a color filter, a printing ink, a liquid ink, a coating composition, a paint, plastics, a film or a fiber.

Based on the organic material to be colored the pigment composition is usually used in an amount of from 0.01 to 30 wt%. In case of the use in color filters, higher amounts may also be used.

Preferably, the pigment composition or pigment dispersion is used for coloring a photosensitive resist formulation for manufacturing color filters, especially for elements in the field of display devices.

Accordingly, in a further aspect the invention relates to a photosensitive resist composition comprising a pigment dispersion, as defined in any aspect herein, a resin, a photopolymerization initiator, an ethylenically unsaturated monomer and a solvent. The pigment dispersion, the photosensitive resist formulation or the color filter of the invention may also comprise one or more further colorants, like pigments and/or dyes, especially diketopyrrolopyrrole pigments, quinacridone pigments, anthraquinone pigments, perylene pigments, azo pigments, isoindoline pigments, isoindolinone pigments, disazo condensation pigments or mixtures thereof.

Suitable pigments are, for example, C.I. Pigment Red 242, 254, 255, a DPP pigment based on 3,6-di(4'-bromo-phenyl)-2,5-dihydropyrrolo[3,4-c]pyrrole-1,4-dione or 3,6-di(4'-cyanophenyl)-2,5-dihydropyrrolo[3,4-c]pyrrole-1,4-dione, Pigment Red 177, C.I. Pigment Yellow 93, 95, 128, 138, 139, 150, 180, 185, 213; or C.I. Pigment Orange 16, 71, 73. Suitable dyes may be yellow, orange or red dyes, like C.I. Solvent Yellow 25, 88, 89, C.I. Solvent Orange 54, 99 or C.I. Solvent Red 125, 130, 160, 225. Suitable dyes are available, for example, as Orasol^{®} Red 330, 363, 365, Orasol Orange 272, 251, Orasol Yellow 152 or Oracet^{®} Red 350 FA.

The further colorant may be present in an amount of ≤ 50 wt%, based on the total weight of pigment (a), preferably ≤ 30 wt%, more preferably of from 0.1 to 20 wt%.

The binder resin is not particularly limited. Examples of binder resins include thermoplastic resins, thermosetting resins or photosensitive resins. Preferably, the binder resin is an alkali-soluble resin having an acidic group like a carboxyl group or hydroxyl group. Examples of such resins include epoxy acrylate resins, novolak resins, polyvinyl phenol resins, acrylic resins, carboxyl-group containing epoxy resins and carboxyl-group containing urethane resins or a mixture thereof. Examples are, for example, disclosed in WO-A-08/101841, page 18, line 28 - page 25, line 21 or WO-A-2006/037728. A preferred binder is an alkali-soluble acrylic resin.

A preferred binder resin is a polymer containing a carboxyl group, particularly a copolymer (hereinafter referred to as "carboxyl group-containing copolymer") of an ethylenically unsaturated monomer having at least one carboxyl group (hereinafter referred to as "carboxyl group-containing unsaturated monomer") and one or more other copolymerizable, ethylenically unsaturated monomers (hereinafter referred to as "other unsaturated monomer").

The proportion of the carboxyl group-containing unsaturated monomer in the carboxyl group-containing copolymer is generally 5 to 50 wt%, preferably 10 to 40 wt%, more preferably 10 to 30 wt%, based on the total weight of the binder. Generally, the other unsaturated monomer is present in the copolymer of from about 10 to about 90% by weight, preferably 20 to 85% by weight and more preferably 50 to 85% by weight and especially 60 to 80% by weight, based on the total weight of the copolymer.

The carboxyl group-containing copolymer is especially a copolymer of (1) a carboxyl group-containing unsaturated monomer comprising acrylic acid and/or methacrylic acid as an essential component, and mono(2-acryloyloxyethyl)ester of succinic acid and/or mono(2-methacryloyloxyethyl)ester of succinic acid in some cases, and (2) at least one monomer selected from the group consisting of styrene, methyl (meth)acrylate, ethyl (meth)acrylate, n-butyl (meth)acrylate, 2-hydroxyethyl (meth)acrylate, allyl (meth) acrylate, benzyl (meth)acrylate, phenyl (meth)acrylate, glycerol mono(meth) acrylate, N-phenylmaleimide, polystyrene macromonomer and polymethyl (meth)acrylate macromonomer.

The copolymers of the resin may be a random copolymer or a block copolymer. The (co)polymers usually have a weight average molecular weight in terms of polystyrene measured by gel permeation chromatography (GPC: tetrahydrofuran as a solvent) (hereinafter referred to as "weight average molecular weight" Mw) of 500 to 1,000,000 g/mol, preferably 1,000 to 500,000, more preferably 3,000 to 100,000. The ratio of the weight average molecular weight to the number average molecular weight is preferably 1 to 5, more preferably 1.5 to 4.

The resin may be present in an amount of about 10 to 200 wt%, preferably 20 to 125 wt%, based on the total weight of the pigment composition comprising pigment (a) and (b) and (c), if present.

The photosensitive resist formulation of the invention includes one or more photoinitiators. Photoresists usually comprise a photoinitiator and a polycross-linkable monomer (negative radical polymerization), a material to cross-link the polymers itself (for example, a photoacid generator or the like) or a material to chemically change the solubility of the polymer in certain developing media.

Examples of suitable photoinitiators are, for example, a compound having a bis-imidazole ring, a benzoin-based compound, an acetophenone-based compound, a benzophenone-based compound, a ketal compound, an α-diketone-based compound, a polynuclear quinone-based compound, a xanthone-based compound, or a triazine-based compound, as disclosed, for example, in WO-A-08/101841, and further an oximeester-based compound, for example, described in EP-A-1095313, WO-A-2006/018405, WO-A-2007/071797, WO-A-2007/071497, WO-A-2007/062963, WO-A-2005/080337, JP-A-2010/049238, WO-A-2008/078678, JP-A-2008/151967, JP-A-2010/015025, JP-A-2010/049238, WO-A-2009/019173 and WO-A-2011/152066. The photoinitiators may be used in combination with a sensitizer, a curing promoting agent, a photo-crosslinking agent or photosensitizer composed of a polymer compound.

The total amount of the photoinitiator is preferably of from 0.01 -10 wt%, more preferably 0.05 - 8 wt% and most preferably 1 - 5 wt%, based on the total solid content of the resist composition.

The ethylenically unsaturated monomer may be a compound having one or more ethylenically unsaturated bonds in the molecule including corresponding oligomers. Typical examples include esters of unsaturated carboxylic acids with polyhydroxy compounds, phosphates containing (meth)acryloyloxy groups, urethane (meth)acrylates of hydroxy (meth)acrylate compounds with polyisocyanate compounds, and epoxy (meth)acrylates of (meth)acrylic acid or hydroxy (meth)acrylate compounds with polyepoxy compounds.

Preferred compounds are polyacrylate monomers, for example, described in WO-A-2006/037728 and WO-A-2007/113107. Examples are polyethylene glycol mono(meth) acrylate, polypropylene glycol mono(meth)acrylate, phenoxyethyl (meth)acrylate, polyethylene glycol di(meth)acrylate, ethylene glycol di(meth)acrylate, trimethylol propane tri(meth)acrylate, neopentylglycol di(meth)acrylate, pentaerythritol tri(meth)acrylate, pentaerythritol tetra(meth)acrylate, dipentaerythritol penta(meth)acrylate, dipentaerythritol hexa(meth)acrylate, dipentaerythritol penta-/hexa acrylate, tri(acryloyloxyethyl) isocyanurate, glycerol 1,3-diglycerolate diacrylate, ethylene glycol diglycerolate diacrylate, poly(ethylene glycol) diglycerolate diacrylate, 1,3-propylene glycol diglycerolate diacrylate, poly(propylene glycol) diglycerolate diacrylate and the like. The unsaturated monomer may be used alone or in any desired mixture.

The total amount of the ethylenically unsaturated monomer is preferably of from 5- 70 wt%, more preferably 5-50 wt% and most preferably 7-30 wt%, based on the total solid content of the resist composition.

Further, the pigment dispersion or resist formulation may comprise various suitable additives known in the art. Examples are polymerization accelerators, crosslinking agents, adhesion improvers, organic carboxylic acids or anhydrides, surfactants, thermal polymerization inhibitors, sensitizing dyes, plasticisers, texture-improving agents, storage stabilizers and the like.

Each component contained in the photosensitive resist formulation is used after dissolution or dispersion in a solvent. Preferably, the pigment dispersion, as described herein-before, may be used. Generally, the dispersion is mixed with the further components, and the mixture is homogenized. Each component may be completely dissolved or may be homogenously dispersed in the solvent. The solvent may be aqueous or non-aqueous, preferably non-aqueous. It is preferable that grains of 5 µm or more, preferably 1 µm or more and more preferably 0.5 µm or more and mixed dusts are removed by means of, e.g., centrifugal separation, a sintered filter or a membrane filter from the photosensitive resist formulation.

Examples of suitable solvents are ethylene glycol monomethyl ether acetate, propylene glycol monomethyl ether acetate, propylene glycol monoethyl ether acetate, diethylene glycol dimethyl ether, cyclohexanone, 2-heptanone, 3-heptanone, ethyl 2-hydroxypropionate, 3-methyl-3-methoxybutyl propionate, ethyl 3-methoxypropionate, methyl 3-ethoxypropionate, ethyl 3-ethoxypropionate, n-butyl acetate, isobutyl acetate, n-amyl acetate, isoamyl acetate, n-butyl propionate, ethyl butyrate, isopropyl butyrate, n-butyl butyrate, and ethylpyruvic acid are preferred from the viewpoint of solubility, pigment dispersibility and coating properties. The solvents may be used alone or in any combination. Also, a high-boiling solvent like γ-butyrolactone may be used in combination with the above-mentioned solvents.

The amount of the solvent in the resist formulation is generally of from 60 to 90 wt%, based on the total weight of the photosensitive resist composition.

The photosensitive resist formulation of the invention may be used for manufacturing a color filter, suitable for use in display devices, especially for LCD devices or OLED devices.

The pigment composition of the invention is preferably useful as a colorant for color filters, for, for example, television screens, liquid crystal displays (LCDs), charge coupled devices (CCDs), or organic light emitting diodes (OLEDs). Further, the pigment composition may be used as colorant for electronic inks ("e-inks") or electronic paper ("e-paper").

The red hue of the pigment composition of the invention is particularly useful for the red-green-blue (R, G, B) color filter set. These three colors are set side by side as separated colored segments and produce a full color picture on illumination from behind. A black matrix may be formed on the substrate before the filter segments are formed. The pigment composition is usually present in the red filter segment.

A manufacturing process for making color filters is well known and may be based on photolithography, ink-jet printing, offset printing, gravure printing, relief printing, screen printing, stamp printing, continuous reversal printing and/or electrodeposition, for example, as described in WO-A-2006/37728. The substrate may be transparent or reflective.

Any transparent substrate suitable to form a color filter may be used, for example, a glass substrate such as a quartz glass, borosilicate glass, alumina silicate glass, or a plastic substrate, like polycarbonate, polyester like polyethylene terephthalate, aromatic polyamide, polyamideimide, polyimide, polyethersulfone, polymethyl methacrylate or the like.

A suitable reflective substrate may be silicon or a transparent substrate, as described herein-before, having a thin film of aluminum, silver, silver/copper/palladium alloy or the like.

Usually, a color filter is produced by coating the photosensitive resist formulation, as defined herein-before, on a substrate, followed by drying, exposing, developing and optionally post-baking to form a film.

In case where the respective color filter segments are formed by a photolithographic method, a photosensitive resist formulation prepared in the form of a solvent developable type or alkali developable type colored resist formulation is coated on a transparent or reflective substrate by a coating method such as spray coating, spin coating, slit coating or roll coating to a thickness of 0.5 to 10 µm when dried. Then, ultraviolet exposure is carried out on the dried coating through a mask having a predetermined pattern provided on the coating in a contact or non-contact state. Then, the uncured portion is removed by immersing the coating in a solvent or alkali developing liquid or by spraying the developing liquid with, e.g., a spray onto the coating. Similar operations are repeated for other colors, preparing the color filter. The photolithographic method may produce color filters having higher precision than those produced by a printing method.

As the alkali developing liquid, an aqueous solution of, e.g., sodium carbonate or sodium hydroxide can be used. Also, an organic alkali such as dimethylbenzylamine or triethanolamine can be used. An anti-foaming agent or a surfactant can be added to the developing liquid. An aqueous developing liquid is preferred.

Further, ultraviolet exposure may be also carried out after coating a water-soluble or alkali-soluble resin, such as a polyvinyl alcohol or a water-soluble acrylic resin on the coated and dried colored resist, and drying the coated resin to form a film which prevents polymerization inhibition caused by oxygen, in order to increase the sensitivity of ultraviolet exposure.

The color filter may also be produced by an electrodeposition method, a transfer method or the like. The electrodeposition method includes the step of electro-depositional formation of the respective color filter segments on a transparent conducting film by electrophoresis of colloidal particles using a transparent conducting film formed on a transparent substrate. The transfer method includes a step of forming a color filter layer in advance on the surface of a removable transfer base sheet, followed by transferring said color filter layer to a desired transparent substrate.

The thickness of the color filter segment after drying is generally of from 0.2 to 10 µm, preferably 0.5 to 5.0 µm, more preferably 1 to 3.0 µm.

In a further preferred aspect, the invention relates to a color filter having a red filter segment, wherein the red filter segment comprises a pigment of formula (I) and a pigment derivative of formula (II),
the red filter segment, after thermal treatment at 230°C for 15 min, has chromaticity coordinates (x,y) of y ≥ 0.285, when x = 0.6500, calculated using a C light source according to 1931 CIE XYZ colorimetric system;
a transmittance Y ≥ 12.5,
and a contrast ratio CR ≥ 3900 in a normal line direction to the segment surface, wherein the maximum luminance is 30,000.

Especially, 0.285 ≤ y ≤ 0.3.

More preferably, the invention relates to a color filter having a red filter segment, wherein the red filter segment comprises
(a) a pigment of formula (I),
(b) at least one polar pigment derivative of formula of formula (II),
   and
(c) a pigment derivative of formula

   (P²) - (Y)ₙ (V)

   , the red filter segment, after thermal treatment at 230°C for 15 min, has chromaticity coordinates (x,y) of y ≥ 0.285, when x = 0.6500, calculated using a C light source according to 1931 CIE XYZ colorimetric system;
   a transmittance Y ≥ 12.5,
   a contrast ratio CR ≥ 3900 in a normal line direction to the segment surface, wherein the maximum luminance is 30,000;
   the contrast ratio CR' after 1 hour at 270°C is at least 80% of the contrast ratio CR.

Advantageously, the contrast ratio CR ≥ 6500, preferably CR ≥7000, more preferably CR ≥ 7500, and most preferably CR ≥ 8000.

An especially preferred pigment derivative of formula (II) is a pigment derivative of formula (XI) and/or (XII), most preferably a pigment derivative of formula (Xla).

In a further aspect the invention relates to a pigment derivative of formulae 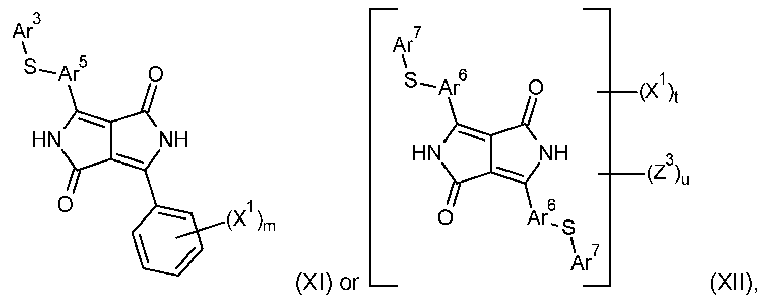 wherein
m is 1 or 2;
X¹ is a group comprising an aliphatic carboxamide group or an aliphatic sulfonamide group;
Ar³ is C₆-C₁₀-aryl or C₂-C₆-heteroaryl, said aryl or heteroaryl is unsubstituted or substituted with R¹⁰ and/or R¹¹;
R¹⁰ and R¹¹ are independently of one another Cl, Br, C₁-C₄-alkyl, OC₁-C₄-alkyl, CF₃ or CN; or
R¹⁰ and R¹¹ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Ar⁵ is phenylene or C₂-C₆-heteroarylene, said phenylene or heteroarylene is unsubstituted or substituted with R²¹;
R²¹ is Cl, Br, C₁-C₄-alkyl, OC₁-C₄-alkyl, CF₃ or CN;
Ar⁶ is at each occurrence selected from phenylene or C₂-C₆-heteroarylene, said phenylene or heteroarylene is unsubstituted or substituted with R²²;
R²² is Cl, Br, C₁-C₄-alkyl, OC₁-C₄-alkyl, CF₃ or CN;
Ar⁷ is at each occurrence selected from C₆-C₁₀-aryl or C₂-C₆-heteroaryl, said aryl or heteroaryl is unsubstituted or substituted with R²³ and/or R²⁴;
R²³ and R²⁴ are independently of one another Cl, Br, C₁-C₄-alkyl, OC₁-C₄-alkyl, CF₃ or CN; or
R²³ and R²⁴ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Z² is SO₃H or a salt thereof;
t is a number of 1 to 4;
u is a number of 0 to 3; and
with the proviso that t+u is 1 to 4.

The group X¹, preferably the group of formula

-A¹-D-G (III)

, may be in meta or para position, preferably in meta position, in the pigment derivative of formula (XI).

Accordingly, preferred is a pigment derivative of formula 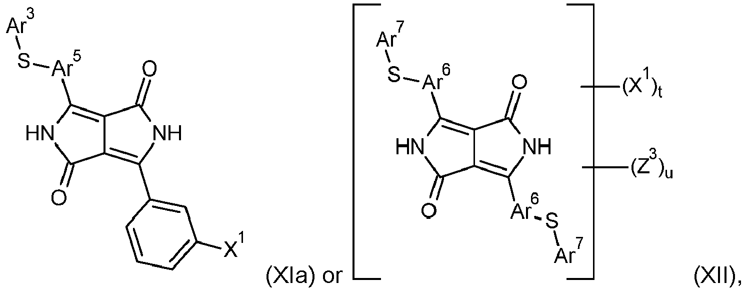 wherein
X¹ is a group of formula

   -A¹-D-G (III)

   ,
A¹ is a direct bond or methylene, preferably a direct bond;
D is -NHCO-, -CO-NR⁵- or -SO₂-NR⁵-, preferably -NHCO-, -CO-NR⁵- or -SO₂-NR⁵-; G is -(C₁-C₄-alkylene)-NR⁶R⁷, said C₁-C₄-alkylene may be interrupted by-NH-;
R⁵ is H;
or G and R⁵ together with the linking nitrogen form a 5- or 6-membered ring, said 6-membered ring may be substituted by C₁-C₄-alkyl and/or interrupted by NR⁸, O or S; R⁶ and R⁷ are independently of one another H or C₁-C₄-alkyl;
or R⁶ and R⁷ together with the linking nitrogen form a 5- or 6-membered ring, said ring may be substituted by C₁-C₄-alkyl and/or interrupted by NR⁸, O or S;
R⁸ is H or C₁-C₄-alkyl;
Ar⁵ and Ar⁶ are independently of one another 1,4-phenylene; 1,4-phenylene substituted with Cl, CH₃, OCH₃; or pyridine-2,5-diyl, preferably 1,4-phenylene; and
Ar³ and Ar⁷ are independently of one another phenyl; phenyl p-substituted with Cl, CH₃ or OCH₃; 2-benzothiazole or 6-methyl-2-benzothiazole, preferably phenyl or phenyl p-substituted with Cl, CH₃ or OCH₃;
Z² is SO₃H or a salt thereof;
t is a number of 1 to 3;
u is a number of 0 to 2, preferably 0 to 1; more preferably 0; and
with the proviso that t+u is 1 to 3.

Especially preferred is a pigment derivative of formula 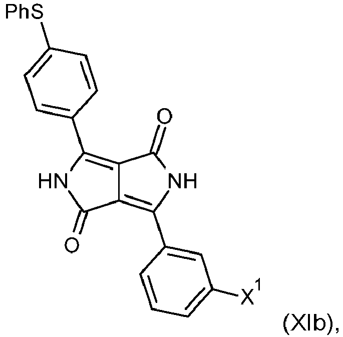 wherein
A is a direct bond or methylene, preferably a direct bond;
D is -NHCO-, -CO-NR⁵- or -SO₂-NR⁵-, preferably -CO-NR⁵- or -SO₂-NR⁵-;
G is -(C₁-C₄-alkylene) - NR⁶R⁷, said C₁-C₄-alkylene may be interrupted by -NH-;
R⁵ is H;
R⁶ and R⁷ are independently of one another H or C₁-C₄-alkyl;
or R⁶ and R⁷ together with the linking nitrogen form a 5- or 6-membered ring, said ring may be substituted by C₁-C₄-alkyl and/or interrupted by NR⁸, O or S; and
R⁸ is H or C₁-C₄-alkyl.

Suitable Examples of a pigment derivative of formula (Xla) or of formula (Xlb) are compounds, wherein the group -A¹-D-G is selected from -SO₂NH(CH₂)₃N(CH₃)₂, -SO₂NH(CH₂)₃N(C₂H₅)₂, -CONH(CH₂)₃N(CH₃)₂, -SO₂NH(CH₂)₃N(nC₄H₉)₂, -CONH(CH₂)₃N(C₂H₅)₂, -CONH(CH₂)₃N(nC₄H₉)₂, 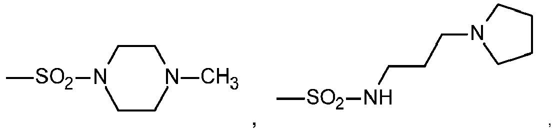 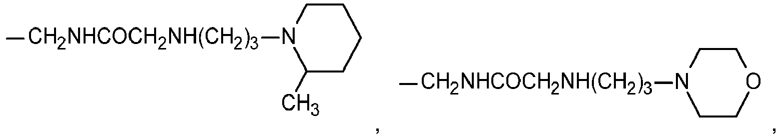 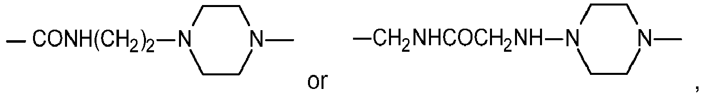 preferably -SO₂NH(CH₂)₃N(CH₃)₂, -SO₂NH(CH₂)₃N(C₂H₅)₂, -CONH(CH₂)₃N(CH₃)₂, -SO₂NH(CH₂)₃N(nC₄H₉)₂, -CONH(CH₂)₃N(C₂H₅)₂, or -CONH(CH₂)₃N(nC₄H₉)₂,

The pigment derivative of formulae (XI) and (XII) is especially suitable for use as a growth inhibitor, preferably in connection with red and orange pigments, especially with diketopyrrolopyrrole pigments. The pigment derivative of formula (XI) is especially formed during a mixed synthesis of a diketopyrrolopyrrole pigment, especially of pigment of formula (I), functioning as a growth inhibitor.

In addition, the pigment derivative of formulae (XI) and (XII) is suitable for use as a pigment synergist, preferably in connection with red and orange pigments, especially with diketopyrrolopyrrole pigments. The pigment derivative may be added before or during the dispersion making process of a pigment.

Further, the pigment derivative of formula (XI) is suitable for use as a red colorant in any application where color is desired.

The pigment compositions of the invention provide hues in the red spectrum which are in demand for use in color filters. There, they provide high contrast ratios and also meet the other requirements, such as high thermal stability, steep and narrow adsorption bands, high color saturation and brightness. In particular, they show a lower transmission between 450-550 nm compared to Pigment Red 177, conventionally used as bluish red pigment in color filter applications, which leads to a higher color saturation.

Advantageously, they provide high contrast ratios after being subjected to a thermal treatment of about 230°C. Especially, when a pigment derivative (c) is present, the thermal stability is excellent, even at a temperature of 270°C.

The color filter of the invention provides a high saturated bluish red color point with a high transmittance, also after a thermal treatment. Thus, a wide color gamut may be provided.

The photosensitive resist formulations are easily processible, especially they show high dispersibility. Further, they show high rheological behavior, like high dispersion stability and high re-crystallization stability, especially, when pigment derivative (b) is formed during the synthesis of pigment of formula (I).

The definitions and preferences given for the pigment mentioned herein-before apply in any combination as well as in any combination for the other aspects of the invention.

The present invention is further illustrated by the following embodiments and combinations of embodiments as indicated by the respective dependencies and back-references. In particular, it is noted that in each instance where a range of embodiments is mentioned, for example in the context of a term such as "The ... of any of embodiments 1 to 4", every embodiment in this range is meant to be explicitly disclosed for the skilled person, i.e. the wording of this term is to be understood by the skilled person as being synonymous to "The ... of any of embodiments 1, 2, 3, and 4". Further, it is explicitly noted that the following set of embodiments is not the set of claims determining the extent of protection, but represents a suitably structured part of the description directed to general and preferred aspects of the present invention.
1. A pigment composition comprising
   (a) a pigment of formula 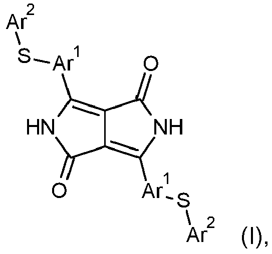 wherein
      Ar¹ is at each occurrence selected from phenylene or C₂-C₆-heteroarylene, said phenylene or heteroarylene is unsubstituted or substituted with R¹;
      Ar² is at each occurrence selected from C₆-C₁₀-aryl or C₂-C₆-heteroaryl, said aryl or heteroaryl is unsubstituted or substituted with R² and/or R³;
      R¹ is Cl, Br, C₁-C₄-alkyl, OC₁-C₄-alkyl, CF₃ or CN;
      R² and R³ are independently of one another Cl, Br, C₁-C₄-alkyl, OC₁-C₄-alkyl, CF₃ or CN; or
      R² and R³ together with the aryl or heteroaryl ring to which they are bonded form an aromatic or heteroaromatic 5- or 6-membered ring, said aromatic or heteroaromatic ring is unsubstituted or substituted with R⁴,
      R⁴ is Cl or C₁-C₄-alkyl; and
   (b) a pigment derivative of formula

      (P¹) - (X¹)ₘ (II)

      , wherein
      P¹ is a residue of a colorant chromophore,
      X¹ is a group comprising an aliphatic carboxamide group, an aliphatic sulfonamide group, a carboxylic acid group or salt thereof, and
      m is 1, 2, 3 or 4.
2. The pigment composition according to embodiment 1, wherein the pigment derivative is of formula (II), wherein X¹ is a group of formula

   - A¹ - D - G (III)

   or

   - A² - E (IV)

   , wherein
   A¹ and A² are independently of one another a direct bond or C₁-C₄-alkylene;
   D is -NH-CO-, -NH-SO₂-, -CO-NR⁵- or-SO₂-NR⁵-;
   G is -(C₁-C₆-alkylene)-NR⁶R⁷ or-(C₁-C₆-alkylene)-NH-NR⁶R⁷, said C₁-C₆-alkylene may be interrupted by -NH-;
   R⁵ is H;
   or G and R⁵ together with the linking nitrogen form a 5- or 6-membered ring, said 5- or 6-membered ring is unsubstituted or substituted with C₁-C₄-alkyl and/or interrupted by NR⁸, O or S;
   R⁶ and R⁷ are independently of one another H or C₁-C₄-alkyl;
   or R⁶ and R⁷ together with the linking nitrogen form a 5- or 6-membered ring, said 5- or 6- membered ring is unsubstituted or substituted with C₁-C₄-alkyl and/or interrupted by NR⁸, O or S;
   R⁸ is H or C₁-C₄-alkyl; and
   E is C₆-C₁₂-aryl substituted with CO₂H or a salt thereof.
3. The pigment composition according to embodiment 1 or 2, wherein the pigment derivative of formula

   (P¹) - (X¹)ₘ (II)

   is a diketopyrrolopyrrole derivative of formula 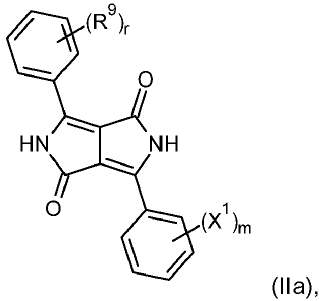 wherein
   m is 1 or 2;
   r is 0, 1 or 2;
   R⁹ is at each occurrence selected from Cl, Br, CF₃, CN, C₁-C₄-alkyl, OC₁-C₄-alkyl, SC₁-C₄-alkyl, Ar³, OAr³ or SAr³;
   Ar³ is C₆-C₁₀-aryl or C₂-C₆-heteroaryl, said aryl or heteroaryl is unsubstituted or substituted with R¹⁰ and/or R¹¹;
   R¹⁰ and R¹¹ are independently of one another Cl, Br, C₁-C₄-alkyl, OC₁-C₄-alkyl, CF₃ or CN; or
   R¹⁰ and R¹¹ together with the aryl or heteroaryl ring to which they are bonded form an aromatic or heteroaromatic ring, said aromatic or heteroaromatic ring is unsubstituted or substituted with Cl or C₁-C₄-alkyl;
   X¹ is a group of formula

      -A¹-D-G (III)

      , wherein
   A¹ is a direct bond or methylene;
   D is -NH-CO-, -CO-NR⁵⁻ or-SO₂-NR⁵-;
   G is -(C₁-C₄-alkylene)-NR⁶R⁷, said C₁-C₄-alkylene may be interrupted by-NH-;
   R⁵ is H;
   or G and R⁵ together with the linking nitrogen form a 6-membered ring, said 6-membered ring may be substituted by C₁-C₄-alkyl and/or interrupted by NR⁸, O or S; R⁶ and R⁷ are independently of one another H or C₁-C₄-alkyl;
   or R⁶ and R⁷ together with the linking nitrogen form a 6-membered ring, said 6-membered ring may be substituted by C₁-C₄-alkyl and/or interrupted by NR⁸, O or S; and
   R⁸ is H or C₁-C₄-alkyl.
4. The pigment composition according to embodiment 1, 2 or 3, wherein the pigment composition further comprises
   (c) a pigment derivative of formula

   (P²) - (Y)ₙ (V)

   , wherein
   P² is a residue of a colorant chromophore; and
   Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
   R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene;
   R¹⁴ is H or C₁-C₄-alkyl; and
   n is 1, 2, 3 or 4.
5. The pigment composition according to at least one of the preceding embodiments, wherein
   the pigment derivative of formula

   (P²) - (Y)ₙ (V)

   is a diketopyrrolopyrrole derivative of formula 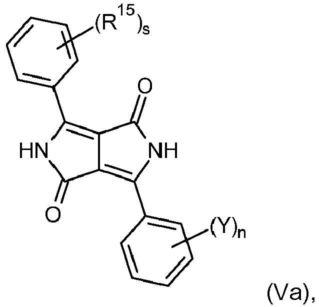 wherein
   n is 1;
   s is 0, 1 or 2
   R¹⁵ is at each occurrence Cl, Br, CF₃, CN, C₁-C₄-alkyl, OC₁-C₄-alkyl, SC₁-C₄alkyl, Ar⁴, OAr⁴ or SAr⁴;
   Ar⁴ is C₆-C₁₀-aryl or C₂-C₆-heteroaryl, said aryl or heteroaryl is unsubstituted or substituted with R¹⁶ and/or R¹⁷;
   R¹⁶ and R¹⁷ are independently of one another Cl, Br, C₁-C₄-alkyl, OC₁-C₄-alkyl, CF₃ or CN; or
   R¹⁶ and R¹⁷ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
   Y is selected from OC₈-C₂₂-alkyl, SC₈-C₂₂-alkyl, OC₁₂-C₂₂-aralkyl, SC₁₂-C₂₂-aralkyl, OC₁₂-C₂₂-alkylaryl, SC₁₂-C₂₂-alkylaryl or NR¹²R¹³,
   R¹² and R¹³ are independently of one another H, C₈-C₂₂-alkyl, C₁₂-C₂₂-aralkyl, or C₁₂-C₂₂-alkylaryl;
   each alkyl group in Y may be interrupted by O, S, NR¹⁴ or phenylene; and
   R¹⁴ is H or C₁-C₄-alkyl.
6. The pigment composition according to at least one of the preceding embodiments, wherein the amount of pigment (a) is at least 65 wt% and the amount of pigment derivative (b) is of from 3 to 35 wt%, based on the total weight of the pigment composition.
7. The pigment composition according to at least one of the preceding embodiments, wherein the pigment composition further comprises
   (d) a pigment derivative of formula

   (Z²)ₚ - (P³) - (A³- Z¹)_{q} (VI)

   , wherein
   P³ is a residue of a colorant chromophore,
   A³ is C₁-C₆-alkylene;
   Z¹ is a N-containing 5-membered heterocycle, preferably a heteroaromatic ring; and
   Z² is SO₃H or a salt thereof, or CO₂H or a salt thereof,
   p is a number of 0 to 2; and
   q is a number of 1 or 2.
8. The pigment composition according to embodiment 7, wherein Z¹ is a group selected from the group consisting of 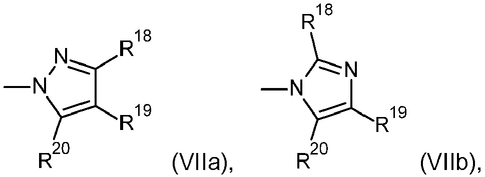 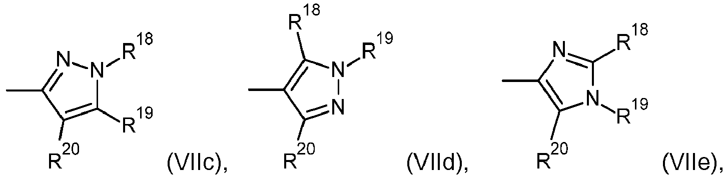 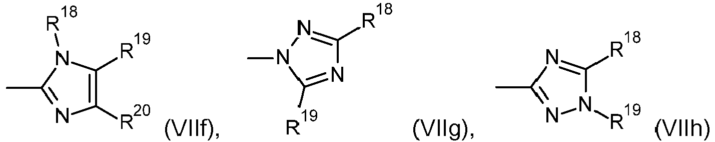 and 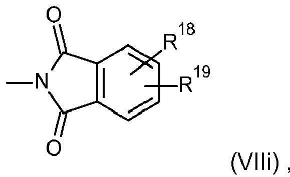 wherein
   R¹⁸, R¹⁹ and R²⁰ are independently of one another H, halogen, C₁-C₁₈-alkyl; C₁-C₁₈-alkyl substituted with halogen, OC₁-C₆-alkyl or di(C₁-C₆-alkyl)amino; C₆-C₁₂-aryl; or C₆-C₁₂-aryl substituted with or C₁-C₁₈-alkyl, halogen, nitro or OC₁-C₆-alkyl;
   two adjacent groups of R¹⁸, R¹⁹ and R²⁰ together with the heteroaryl ring to which they are bonded form a 5-7-membered alicyclic, aromatic or heteroaromatic ring.
9. A pigment composition according to at least one of the preceding embodiments, wherein the colorant chromophore P1 is selected from the group consisting of a diketopyrrolopyrrole, a quinacridone, a dihydroquinacridone, a quinacridonequinone, an aminoanthraquinone and a perylene, said chromophore is unsubstituted or substituted.
10. A process for preparing a pigment composition, as defined in any one of embodiments 1 to 9, wherein P¹ and P² are a residue of a diketopyrrolopyrrole chromophore,
   which process comprises reacting a succinic diester with a compound of formula NC - Ar¹ - S - Ar² (VIII), a compound of formula 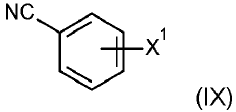 and optionally a compound of formula 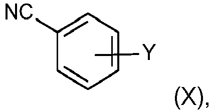 wherein
   Ar¹ is phenylene or C₂-C₆-heteroarylene, said phenylene or heteroarylene is unsubstituted or substituted with R¹;
   Ar² is C₆-C₁₀-aryl or C₂-C₆-heteroaryl, said aryl or heteroaryl is unsubstituted or substituted with R² and/or R³;
   R¹ is Cl, Br, C₁-C₄-alkyl, OC₁-C₄-alkyl, CF₃ or CN;
   R² and R³ are independently of one another Cl, Br, C₁-C₄-alkyl, OC₁-C₄-alkyl, CF₃ or CN; or
   R² and R³ together with the aryl or heteroaryl ring to which they are bonded form an aromatic or heteroaromatic 5- or 6-membered ring, said aromatic or heteroaromatic ring is unsubstituted or substituted with R⁴,
   R⁴ is Cl or C₁-C₄-alkyl;
   X¹ is a group comprising an aliphatic carboxamide group or an aliphatic sulfonamide group;
   Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
   R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene; and
   R¹⁴ is H or C₁-C₄-alkyl.
11. A pigment dispersion comprising a pigment composition, as defined in any one of embodiments 1 to 9 or obtainable according to embodiment 10, and a polymeric dispersant.
12. A photosensitive resist formulation comprising a pigment dispersion, as defined in embodiment 11, a resin, a photopolymerization initiator, an ethylenically unsaturated monomer and a solvent.
13. A color filter comprising a pigment composition, as defined in any of embodiments 1 to 9 or obtainable according to embodiment 10.
14. The use of a pigment composition, as defined in any one of embodiments 1 to 9 or obtainable according to embodiment 10, for coloring a photosensitive resist formulation for manufacturing a color filter, a printing ink, a liquid ink, a coating composition, a paint, plastics, a film or a fiber.
15. A pigment derivative of formulae 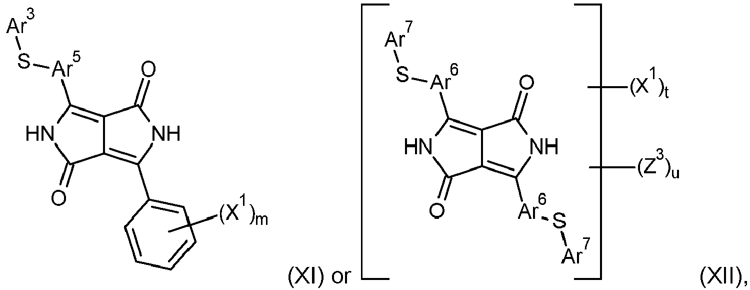 wherein
   m is 1 or 2;
   X¹ is a group comprising an aliphatic carboxamide group or an aliphatic sulfonamide group;
   Ar³ is C₆-C₁₀-aryl or C₂-C₆-heteroaryl, said aryl or heteroaryl is unsubstituted or substituted with R¹⁰ and/or R¹¹;
   R¹⁰ and R¹¹ are independently of one another Cl, Br, C₁-C₄-alkyl, OC₁-C₄-alkyl, CF₃ or CN; or
   R¹⁰ and R¹¹ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
   Ar⁵ is phenylene or C₂-C₆-heteroarylene, said phenylene or heteroarylene is unsubstituted or substituted with R²¹;
   R²¹ is Cl, Br, C₁-C₄-alkyl, OC₁-C₄-alkyl, CF₃ or CN;
   Ar⁶ is at each occurrence selected from phenylene or C₂-C₆-heteroarylene, said phenylene or heteroarylene is unsubstituted or substituted with R²²;
   R²² is Cl, Br, C₁-C₄-alkyl, OC₁-C₄-alkyl, CF₃ or CN;
   Ar⁷ is at each occurrence selected from C₆-C₁₀-aryl or C₂-C₆-heteroaryl, said aryl or heteroaryl is unsubstituted or substituted with R²³ and/or R²⁴;
   R²³ and R²⁴ are independently of one another Cl, Br, C₁-C₄-alkyl, OC₁-C₄-alkyl, CF₃ or CN; or
   R²³ and R²⁴ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
   Z² is SO₃H or a salt thereof;
   t is a number of 1 to 4;
   u is a number of 0 to 3; and
   with the proviso that t+u is 1 to 4.

The present invention will now be explained in more detail with reference to the following examples. These examples should not be construed as limited. Unless otherwise stated, "%" is always % by weight (wt%).

### EXAMPLES

Chromaticity: Chromaticity (Y, x, y) under C-light source was measured using a UV/VIS spectrophotometer (Agilent^{®} UVA/is 8435) and calculated with x = 0.6500 using a C light source according to 1931 CIE XYZ colorimetric system.

Contrast ratio: The contrast ratio was measured with a contrast ratio measurement device (CT-1, maximum luminance 30,000:1, Tsubosaka Electric Co. Ltd).

### General procedure of manufacturing a color filter

A formulation as below is put in a glass bottle of 30 ml:
1 g of pigment composition of Examples 2-19 and 21-25 and Comparative Examples 1 to 4 (including the synergist)
0.5 g of Efka PX 4700 (80 wt%; solvent-based dispersant of acrylic block copolymer)
7.3 g of propylene glycol monomethyl ether acetate (PGMEA)
2.43 g of binder (copolymer of benzyl methacrylate and hydroxyethyl methacrylate 6:1, molecular weight Mw = ∼ 32 kDa, 38% in PGMEA)

The formulation was mixed with 30 g of zirconium oxide beads (φ 0.5 mm) and shaken in a Skandex^{®} apparatus for 15 hours. The beads were filtered off, and 5 g of the dispersion were mixed with 0.36 g of Sartomer^{®} 399 (dipentaerythritol pentaacrylate) and 0.1 g of Irgacure^{®} OXE 02 on a Vortex^{®} mixing apparatus for 10 min.

The formulation (resist) was spin coated on a glass substrate with a spin speed between 500 and 1000 rpm, dried at 80°C for 5 min on a hot plate, exposed with an LED lamp (365 nm, +/- 10 mJ/cm², 10-20 s) and baked on a hot plate at 230°C for 1 hour. The contrast ratios of the obtained red filter segments were measured.

In order to determine the thermal stability, the contrast ratios were measured after heat treatment at 270°C for an additional hour.

### Example 1: Synthesis of N-[3-(diethylamino)propyl]-3-[3,6-dioxo-1-(4-phenylsulfanylphenyl)-2,5-dihydropyrrolo[3,4-c]pyrrol-4-yl]benzamide

47.8 g of 3-[1-(4-chlorophenyl)-3,6-dioxo-2,5-dihydropyrrolo[3,4-c]pyrrol-4-yl]-N-[3-(diethylamino)propyl]benzamide, prepared in analogy to Example 1010 in WO-A-09/144115, and 34.6 g of potassium carbonate were added to 600 ml of N,N-dimethylacetamide under nitrogen atmosphere and heated in an oil bath of 80°C. After reaching 60°C, 11.0 g of thiophenol were added dropwise over 30 min. The reaction mixture was stirred at 75°C overnight until thiophenol could no longer been smelled in an acidified spot test. After cooling the reaction mixture was added over 5 min to a mixture of 800 g of ice and 1.5 I of water and stirred for 1 hour. The red precipitation was filtered and washed with 1 I of water, then 1 I of methanol and again 1 I of water. The resulting red press cake was dried overnight at 60°C and 200 mbar to afford 52.5 g of a red crystalline powder comprising a compound of formula (Xle) as main component: 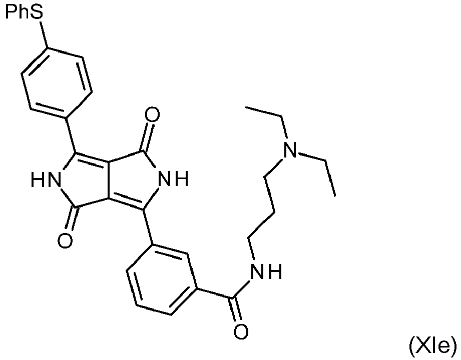 ¹H-NMR (400MHz, D₂SO₄): 8.40 (1H, bs, H_{Ar}); 8.38 (1H, bd, H_{Ar}); 8.09 (1H, bs, H_{Ar}); 8.07 (2H, bs, H_{Ar}); 8.40 (1H, bs, H_{Ar}); 8.01-7.99 (2H, m, H_{Ar}); 7.93 (1H, bt, H_{Ar}); 7.78 (2H, bd, H_{Ar}); 7.40 (2H, bd, H_{Ar}); 3.84 (2H, m, CH₂-NH-CO); 3.20 (6H, m, (CH₂N); 2.21 (2H, m, CH₂-CH₂-CH₂); 1.31 (6H, t, CH₃).

MALDI-ToF (m/z, negative mode): 553.2 ((M+1)-, 43%); 552.2 (M-, 77%); 552.2 ((M-1)-, 100%); 475.4 ((M-77)-, 36%); 394.5 ((M-158)-, 16%); 318.6 ((M-234)-, 16%). MALDI-ToF (m/z, positive mode): 576.3 ((M+24)⁺, 13%); 554.5 (M+2)⁺, 44%); 481.5 ((M-71)⁺, 48%); 424.0 ((M-128)⁺, 32%); 396 ((M-156)⁺, 39%); 112.9 ((M-440)⁺, 67%); 86.8 ((M-465)⁺, 67%).

### Example 2

Example 2 was prepared according to Example 1b of WO-A-2004/00764. 0.765 g of the obtained pigment was dry-blended with 0.135 g of the compound of Example 1.

| x | y | Y | Contrast ratio |
|---|---|---|---|
| 0.6500 | 0.2959 | 13.89 | 4000 |

### Example 3

Example 3 was prepared according to Example 6 of WO-A-2005/040284. 0.765 g of the obtained pigment was dry-blended with 0.135 g of the compound of Example 1.

| x | y | Y | Contrast ratio | Thermal stability after 1 hour at 270°C |
|---|---|---|---|---|
| 0.6500 | 0.2961 | 13.89 | 4200 | 90.5% |

### Example 4

97.0 g of t-amyl alcohol were reacted under inert gas (N₂) with 12.1 g (0.53 mol) of sodium at 130°C under reflux. To the resultant solution, a mixture, heated to 60°C, of 38.5 g of t-amyl alcohol, 39 g of succinic acid di-t-amyl ester, 55.2 g (261.25 mmol) of 4-(phenylsulfanyl)benzonitrile and 3.57 g (13.75 mmol) of compound of formula 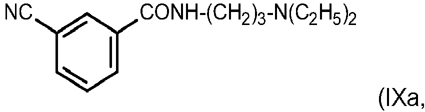 prepared in analogy to Example 1004 of WO-A-2009/144115) was added thereto within 3 to 4 hours, while the internal temperature was lowered to 90°C. The resultant suspension was stirred for further 18 hours and then metered into a mixture of 1174 g of ice/water, 214 g of methanol and 31 g of sulfuric acid (96%), which was previously prepared and cooled to -10 to -15°C, while the final temperature was kept below -5°C. 30 g of t-amyl alcohol were used to rinse the initial reactor and also transferred to the reaction mixture. After 2 hours stirring at -5°C, the mixture was heated to 10°C and further stirred for 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (Ia) and compound of formula (Xle). 0.765 g of the obtained pigment was dry-blended with 0.135 g of the compound of Example 1.

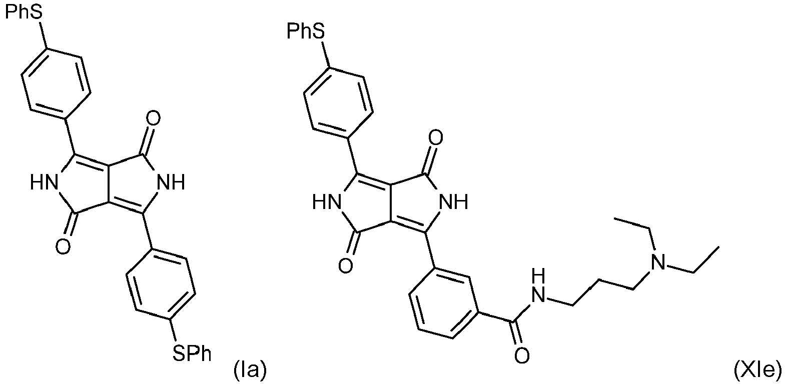

| x | y | Y | Contrast ratio |
|---|---|---|---|
| 0.6500 | 0.2954 | 14.15 | 8500 |

### Example 5

Example 4 was repeated with the exception of that the obtained pigment powder was dry-blended with the product obtained in Example 2 of EP-A-0485337 (a pigment derivative (d)) instead of the compound of Example 1.

| x | y | Y | Contrast ratio |
|---|---|---|---|
| 0.6500 | 0.2913 | 12.62 | 6600 |

### Example 6

97.0 g of t.-amyl alcohol were reacted under inert gas (N₂) with 12.1 g (0.53 mol) of sodium at 130°C under reflux. To the resultant solution, a mixture, heated to 60°C, of 38.5 g of t-amyl alcohol, 39 g of succinic acid di-t-amyl ester, 52.29 g (247.5 mmol) of 4-(phenylsulfanyl)benzonitrile, 3.57 g (13.75 mmol) of compound of formula (IXa) and 1.76 g (13.75 mmol) of 1,3-dicyanobenzene was added thereto within 3 to 4 hours, while the internal temperature was lowered to 90°C. The resultant suspension was stirred for further 18 hours and then metered into a mixture of 1174 g of ice/water, 214 g of methanol and 31 g of sulfuric acid (96%), which was previously prepared and cooled to -10 to -15°C, while the final temperature was kept below -5°C. 30 g of t-amyl alcohol were used to rinse the initial reactor and also transferred to the reaction mixture. After 2 hours stirring at -5°C, the mixture was heated to 30°C and further stirred for 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (Ia) and compound of formula (Xle).

0.765 g of the obtained pigment powder was dry-blended with 0.135 g of the compound of Example 1.

| x | y | Y | Contrast ratio |
|---|---|---|---|
| 0.6500 | 0.2941 | 13.41 | 8400 |

### Example 7

97.0 g of t.-amyl alcohol were reacted under inert gas (N₂) with 12.1 g (0.53 mol) of sodium at 130°C under reflux. To the resultant solution, a mixture, heated to 60°C, of 38.5 g of t-amyl alcohol, 39 g of succinic acid di-t-amyl ester, 52.29 g (247.5 mmol) of 4-(phenylsulfanyl)benzonitrile, 3.57 g (13.75 mmol) of compound of formula (IXa) and 1.76 g (13.75 mmol) of 1,3-dicyanobenzene was added thereto within 3 to 4 hours, while the internal temperature was lowered to 90°C. The resultant suspension was stirred for further 18 hours and then metered into a mixture of 1174 g of ice/water and 214 g of methanol, which was previously prepared and cooled to -10 to -15°C, while the final temperature was kept below -5°C. 30 g of t-amyl alcohol were used to rinse the initial reactor and also transferred to the reaction mixture. After 2 hours stirring at - 5°C, the mixture was heated to 20°C and further stirred for 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (Ia) and compound of formula (Xle).
0.765 g of the obtained pigment powder was dry-blended with 0.135 g of the compound of Example 1.

| x | y | Y | Contrast ratio |
|---|---|---|---|
| 0.6500 | 0.2956 | 14.03 | 8400 |

### Example 8

Example 7 was repeated with the exception that the obtained pigment powder was dry-blended with the product obtained in Example 2 of EP-A-0485337 (a pigment derivative (d)) instead of the compound of Example 1.

| x | y | Y | Contrast ratio |
|---|---|---|---|
| 0.6500 | 0.2935 | 13.46 | 8400 |

### Example 9

97.0 g of t-amyl alcohol were reacted under inert gas (N₂) with 12.1 g (0.53 mol) of sodium at 130°C (bath temperature) under reflux. To the resultant solution, a mixture, heated to 60°C, of 38.5 g of t-amyl alcohol, 39 g of succinic acid di-t-amyl ester, 52.29 g (247.5 mmol) of 4-(phenylsulfanyl)benzonitrile, 5.71 g (22 mmol) of compound of formula (IXa) and 2.0 g (5.5 mmol) of 4-n-octadecylthiobenzonitrile was added thereto within 3 to 4 hours, while the internal temperature was lowered to 90°C. The resultant suspension was stirred for further 18 hours and then metered into a mixture of 1174 g of ice/water, 214 g of methanol and 31 g of sulfuric acid (96%), which was previously prepared and cooled to -10 to -15°C, while the final temperature did not exceed -5°C. 30 g of t-amyl alcohol were used to rinse the initial reactor and also transferred to the reaction mixture. After 2 hours stirring at -5°C, the reaction mixture was heated to 30°C and further stirred for a total of 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (la), compound of formula (Xle) and compound of formula (Vh).

0.765 g of the obtained pigment powder was dry-blended with the product obtained in Example 2 of EP-A-0485337 (a pigment derivative (d)).

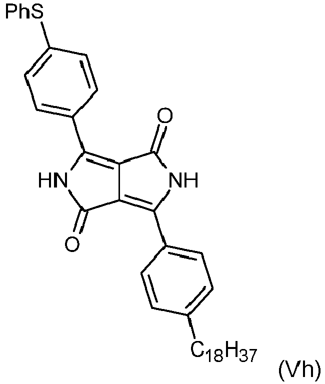

| x | y | Y | Contrast ratio | Thermal stability after 1 hour at 270°C |
|---|---|---|---|---|
| 0.6500 | 0.2938 | 13.87 | 8500 | 91.8% |

### Example 10

Example 9 was repeated with the exception of using 54.62 g (258.5 mmol) of 4-(phenylsulfanyl)benzonitrile, 3.57 g (13.75 mmol) of compound of formula (IXa) and 1.0 g (2.75 mmol) of 4-n-octadecylthiobenzonitrile (as a third nitrile) and the ripening temperature of 20°C after hydrolysis (>90% yield). The product mainly consists of compound of formula (la), compound of formula (Xle) and compound of formula (Vh).

| x | y | Y | Contrast ratio | Thermal stability after 1 hour at 270°C |
|---|---|---|---|---|
| 0.6500 | 0.2959 | 14.36 | 8000 | 90.2% |

### Example 11

Example 9 was repeated with the exception of using 52.29 g (247.5 mmol) of 4-(phenylsulfanyl)benzonitrile, 3.57 g (13.75 mmol) of compound of formula (IXa) and 5.0 g (13.75 mmol) of 4-n-octadecylthiobenzonitrile (as a 3^{rd} nitrile) and the ripening temperature of 0°C after hydrolysis (>90% yield). The product mainly consists of compound of formula (la), compound of formula (Xle) and compound of formula (Vh).

| x | y | Y | Contrast ratio | Thermal stability after 1 hour at 270°C |
|---|---|---|---|---|
| 0.6500 | 0.2966 | 14.51 | 7900 | 96% |

### Example 12

97.0 g of t-amyl alcohol were reacted under inert gas (N₂) with 12.1 g (0.53 mol) of sodium at 130°C (bath temperature) under reflux. To the resultant solution, a mixture, heated to 60°C, of 38.5 g of t-amyl alcohol, 39 g of succinic acid di-t-amyl ester, 51.13 g (242 mmol) of 4-(phenylsulfanyl)benzonitrile, 5.71 g (22 mmol) of compound of formula (IXa), 0.70 g (5.5 mmol) of 1,3-dicyanobenzene and 2.0 g (5.5 mmol) of 4-n-octadecylthiobenzonitrile was added thereto within 3 to 4 hours, while the internal temperature was lowered to 90°C. The resultant suspension was stirred for further 18 hours and then metered into a mixture of 1174 g of ice/water, 214 g of methanol and 31 g of sulfuric acid (96%), which was previously prepared and cooled to -10 to -15°C, while the final temperature did not exceed -5°C. 30 g of t-amyl alcohol were used to rinse the initial reactor and also transferred to the reaction mixture. After 2 hours stirring at -5°C, the reaction mixture was heated to 30°C and further stirred for a total of 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (Ia), compound of formula (Xle) and compound of formula (Vh). 0.765 g of the obtained pigment powder was dry-blended with 0.135 g of the compound of Example 1.

| x | y | Y | Contrast ratio | Thermal stability after 1 hour at 270°C |
|---|---|---|---|---|
| 0.6500 | 0.2964 | 14.26 | 10200 | 92.2% |

### Example 13

Example 12 was repeated with the exception that the obtained pigment powder was dry-blended with the product obtained in Example 2 of EP-A-0485337 (a pigment derivative (d)) instead of the compound of Example 1.

| x | y | Y | Contrast ratio | Thermal stability after 1 hour at 270°C |
|---|---|---|---|---|
| 0.6500 | 0.2930 | 14.68 | 9900 | 96% |

### Example 14

97.0 g of t-amyl alcohol were reacted under inert gas (N₂) with 12.1 g (0.53 mol) of sodium at 130°C (bath temperature) under reflux. To the resultant solution, a mixture, heated to 60°C, of 38.5 g of t-amyl alcohol, 39 g of succinic acid di-t-amyl ester, 51.13 g (242 mmol) of 4-(phenylsulfanyl)benzonitrile, 5.71 g (22 mmol) of compound of formula (IXa), 0.70 g (5.5 mmol) of 1,4-dicyanobenzene and 2.0 g (5.5 mmol) of 4-n-octadecylthiobenzonitrile was added thereto within 3 to 4 hours, while the internal temperature was lowered to 90°C. The resultant suspension was stirred for further 18 hours and then metered into a mixture of 1174 g of ice/water, 214 g of methanol and 31 g of sulfuric acid (96%), which was previously prepared and cooled to -10 to -15°C, while the final temperature did not exceed -5°C. 30 g of t-amyl alcohol were used to rinse the initial reactor and also transferred to the reaction mixture. After 2 hours stirring at -5°C, the reaction mixture was heated to 30°C and further stirred for a total of 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (Ia), compound of formula (Xle) and compound of formula (Vh).
0.765 g of the obtained pigment powder was dry-blended with 0.135 g of the compound of Example 1.

| x | y | Y | Contrast ratio | Thermal stability after 1 hour at 270°C |
|---|---|---|---|---|
| 0.6500 | 0.2949 | 13.02 | 9500 | 94.7% |

### Example 15

Example 14 was repeated with the exception that 0.765 g of the obtained pigment powder was dry-blended with 0.135 g of the product obtained in Example 2 of EP-A-0485337 (a pigment derivative (d)) instead of the compound of Example 1.

| x | y | Y | Contrast ratio | Thermal stability after 1 hour at 270°C |
|---|---|---|---|---|
| 0.6500 | 0.2908 | 12.18 | 9500 | 80.2% |

### Example 16

97.0 g of t-amyl alcohol were reacted under inert gas (N₂) with 12.1 g (0.53 mol) of sodium at 130°C (bath temperature) under reflux. To the resultant solution, a mixture, heated to 60°C, of 38.5 g of t-amyl alcohol, 39 g of succinic acid di-t-amyl ester, 55.78 g (264 mmol) of 4-(phenylsulfanyl)benzonitrile, 0.70 g (5.5 mmol) of 1,3-dicyanobenzene and 2.0 g (5.5 mmol) of 4-n-octadecylthiobenzonitrile was added thereto within 3 to 4 hours, while the internal temperature was lowered to 90°C. The resultant suspension was stirred for further 18 hours. Then, 6.9 g of the product prepared according to Example QAD 3 of WO-A-2007060254 was added, and the resultant mixture was metered into a mixture of 1174 g of ice/water, 214 g of methanol and 31 g of sulfuric acid (96%), which was previously prepared and cooled to -10 to - 15°C, while the final temperature did not exceed -5°C. 30 g of t-amyl alcohol were used to rinse the initial reactor and also transferred to the reaction mixture. After 2 hours stirring at -5°C, the reaction mixture was heated to 30°C and further stirred for a total of 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (Ia), compound of formula (Xle) and compound of formula (Vh).
0.765 g of the obtained pigment powder was dry-blended with the product obtained in Example 2 of EP-A-0485337 (a pigment derivative (d)).

| x | y | Y | Contrast ratio | Thermal stability after 1 hour at 270°C |
|---|---|---|---|---|
| 0.6500 | 0.2993 | 13.00 | 8100 | 96% |

### Example 17

Example 12 was repeated with the exception of using 52.88 g (250.25 mmol) of 4-(phenylsulfanyl)benzonitrile, 4.99 g (19.25 mmol) of compound of formula (IXa), 0.35 g (2.75 mmol) of 1,3-dicyanobenzene and 1.0 g (2.75 mmol) of 4-n-octadecylthiobenzonitrile.
0.765 g of the obtained pigment powder was dry-blended with 0.135 g of the compound of Example 1.

| x | y | Y | Contrast ratio | Thermal stability after 1 hour at 270°C |
|---|---|---|---|---|
| 0.6500 | 0.2969 | 14.42 | 9400 | 95.7% |

### Example 18

Example 17 was repeated with the exception that 0.765 g of the obtained pigment powder was dry-blended with 0.135 g of the product obtained in Example 2 of EP-A-0485337 (a pigment derivative (d)) instead of the compound of Example 1).

| x | y | Y | Contrast ratio | Thermal stability after 1 hour at 270°C |
|---|---|---|---|---|
| 0.6500 | 0.2936 | 13.83 | 8600 | 90.7% |

### Example 19

Example 18 was repeated with the exception of the ripening temperature of 40°C (>90% yield).
0.765 g of the obtained pigment powder was dry-blended with 0.101 g of the product obtained in Example 2 of EP-A-0485337 (a pigment derivative (d)) and 0.034 g of the product prepared according to Example 1b of GB-A-2238550.

| x | y | Y | Contrast ratio | Thermal stability after 1 hour at 270°C |
|---|---|---|---|---|
| 0.6500 | 0.2952 | 14.15 | 7400 | 94.6% |

### Example 20

30.1 g of pigment of formula (I), prepared according to Example 1b of WO-A-2004/00764, were added to 171 ml of chlorosulfuric acid under cooling with ice. Then, the mixture was heated to 80°C, and 23.6 g of thionyl chloride were added dropwise thereto. After cooling the mixture was stirred for 15 hours. The mixture was dropwise added to a mixture of 800 g of ice and 400 g of water, while the temperature was kept at ≤ 5°C. The resulting suspension was filtered, and the residue was added under stirring to a mixture of 85 g of ice, 85 g of water and 18.4 g of N,N-diethyl-1,3-propanediamine. The resulting suspension was heated to 50°C for 2 hours, filtered, washed with water and dried. A red solid product of formula (XII) was obtained (yield 92%), wherein t is ca. 1.6 according to ¹H NMR. 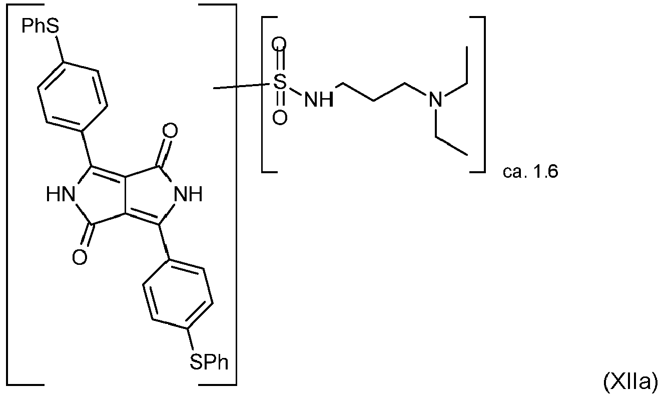 ¹H-NMR (400MHz, D₂SO₄): 8.32-7.48 (18H, m, H_{Ar}); 6.08 (bs, NH); 3.61 (ca. 1.6x2H, m, NHCH₂); 3.24 (ca. 1.6x6H, m, (CH₂N); 2.24 (ca. 1.6x2H, m, CH₂-CH₂-CH₂); 1.35 (ca. 1.6x6H, t, CH₃)

### Example 21

Example 12 was repeated with the exception that the hydrolysis was carried out with acetic acid (100%) and the ripening temperature was 25°C (>90% yield).
0.765 g of the obtained pigment powder was dry-blended with 0.135 g of the product prepared according to Example 20.

| x | y | Y | Contrast ratio | Thermal stability after 1 hour at 270°C |
|---|---|---|---|---|
| 0.6500 | 0.2966 | 14.03 | 8100 | 86.4% |

### Example 22

97.0 g of t-amyl alcohol were reacted under inert gas (N₂) with 12.1 g (0.53 mol) of sodium at 130°C (bath temperature) under reflux. To the resultant solution, a mixture, heated to 60°C, of 38.5 g of t-amyl alcohol, 39 g of succinic acid di-t-amyl ester, 52.88 g (250.25 mmol) of 4-(phenylsulfanyl)benzonitrile, 3.57 g (13.75 mmol) of compound of formula (IXa), 0.70 g (5.5 mmol) of 1,3-dicyanobenzene and 2.0 g (5.5 mmol) of 4-n-octadecylthiobenzonitrile was added thereto within 3 to 4 hours, while the internal temperature was lowered to 90°C. The resultant suspension was stirred for further 18 hours. Then, 6.9 g of the product obtained in Example 2 of EP-A-0485337 was added, and the resultant mixture was metered into a mixture of 1174 g of ice/water, 214 g of methanol and 31 g of sulfuric acid (96%), which was previously prepared and cooled to -10 to -15°C, while the final temperature did not exceed -5°C. 30 g of t-amyl alcohol were used to rinse the initial reactor and also transferred to the reaction mixture. After 2 hours stirring at -5°C, the reaction mixture was heated to 30°C and further stirred for a total of 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (Ia), compound of formula (Xle), compound of formula (Vh) and the product obtained in Example 2 of EP-A-0485337.
0.765 g of the obtained pigment powder was dry-blended with the product obtained in Example 2 of EP-A-0485337 (a pigment derivative (d)).

| x | y | Y | Contrast ratio | Thermal stability after 1 hour at 270°C |
|---|---|---|---|---|
| 0.6500 | 0.2930 | 13.52 | 9200 | 94.5% |

### Example 23

Example 22 was repeated with the exception that 0.765 g of the obtained pigment powder was dry-blended with 0.135 g of the compound of Example 1 (instead of the product obtained in Example 2 of EP-A-0485337).

| x | y | Y | Contrast ratio | Thermal stability after 1 hour at 270°C |
|---|---|---|---|---|
| 0.6500 | 0.2930 | 13.52 | 8800 | 96.5% |

### Example 24

Example 22 was repeated with the exception of using 51.13 g (241 mmol) of 4-(phenylsulfanyl)benzonitrile, 5.71 g (22 mmol) of compound of formula (IXa), 0.70 g (5.5 mmol) of 1,3-dicyanobenzene, 2.0 g (5.5 mmol) of 4-n-octadecylthiobenzonitrile and 6.9 g of the product obtained in Example 2 of EP-A-0485337.

| x | y | Y | Contrast ratio | Thermal stability after 1 hour at 270°C |
|---|---|---|---|---|
| 0.6500 | 0.2928 | 13.48 | 9300 | 94.6% |

### Example 25

Example 24 was repeated with the exception that 0.765 g of the obtained pigment powder was dry-blended with 0.09 g of the product obtained in Example 2 of EP-A-0485337 and 0.045 g of the product prepared according to Example 1 of WO-A-02/00643.

| x | y | Y | Contrast ratio | Thermal stability after 1 hour at 270°C |
|---|---|---|---|---|
| 0.6500 | 0.2928 | 13.48 | 9200 | 88% |

The color filter resist compositions made with Examples 3, 4, 14, 16, 17 and 23 were tested with respect to storage stability (dispersion stability). After one week storing at 40°C the resist formulations did not significantly change their viscosity behavior.

### Comparative Example 1

Comparative Example 1 was prepared in analogy to Example 48 of US 4,579,949 with the exception that the equivalent amount of benzonitrile was replaced by the product of Example 1a of WO-A-2004/007604.
0.765 g of the obtained pigment powder was dry-blended with the product obtained in Example 2 of EP-A-0485337 (a pigment derivative (d)).

### Comparative Example 2

Comparative Example 2 was prepared according to Example 6 of WO-A-2005/040284. 0.765 g of the obtained pigment powder was dry-blended with the product obtained in Example 2 of EP-A-0485337 (a pigment derivative (d)).

### Comparative Example 3

Comparative Example 3 was prepared according to Example 6B of WO-A-2005/040284.
0.765 g of the obtained pigment powder was dry-blended with the product obtained in Example 2 of EP-A-0485337 (a pigment derivative (d)).

### Comparative Example 4

97.0 g of t-amyl alcohol were reacted under inert gas (N₂) with 12.1 g (0.53 mol) of sodium at 130°C (bath temperature) under reflux. To the resultant solution, a mixture, heated to 60°C, of 38.5 g of t-amyl alcohol, 39 g of succinic acid di-t-amyl ester, 52.29 g (247.5 mmol) of 4-(phenylsulfanyl)benzonitrile and 10.0 g (27.5 mmol) of 4-n-octadecylthiobenzonitrile was added thereto within 3 to 4, while the internal temperature was lowered to 90°C. The resultant suspension was stirred for further 18 hours. The suspension was metered into a mixture of 1174 g of ice/water, 214 g of methanol, while the final temperature did not exceed -5°C. 30 g of t-amyl alcohol were used to rinse the initial reactor and also transferred to the reaction mixture. After 2 hours stirring at -5°C, the mixture was heated to 10°C and further stirred for a total of 18 hours. The resulting suspension was filtered, and the filter cake was washed with methanol and water until the washings were colorless and salt-free (conductivity < 100 µS) and then dried by lyophilization to afford a fine bluish-shade red powder (>90% yield). The product mainly consists of compound of formula (Ia) and compound of formula (Vh).
0.765 g of the obtained pigment powder was dry-blended with the product obtained in Example 2 of EP-A-0485337 (a pigment derivative (d)).

| Comp. Ex. | x | y | Y | Contrast ratio |
|---|---|---|---|---|
| 1 | 0.6500 | 0.2927 | 13.31 | 2000 |
| 2 | 0.6500 | 0.2927 | 12.93 | 3800 |
| 3 | 0.6500 | 0.2928 | 13.67 | 1800 |
| 4 | 0.6500 | 0.2933 | 13.88 | 1200 |

## Claims

1. A pigment composition comprising
(a) a pigment of formula 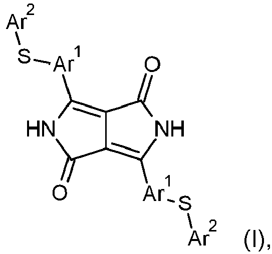 wherein
Ar¹ is at each occurrence selected from phenylene or C₂-C₆-heteroarylene, said phenylene or heteroarylene is unsubstituted or substituted with R¹;
Ar² is at each occurrence selected from C₆-C₁₀-aryl or C₂-C₆-heteroaryl, said aryl or heteroaryl is unsubstituted or substituted with R² and/or R³;
R¹ is Cl, Br, C₁-C₄-alkyl, OC₁-C₄-alkyl, CF₃ or CN;
R² and R³ are independently of one another Cl, Br, C₁-C₄-alkyl, OC₁-C₄-alkyl, CF₃ or CN; or
R² and R³ together with the aryl or heteroaryl ring to which they are bonded form an aromatic or heteroaromatic 5- or 6-membered ring, said aromatic or heteroaromatic ring is unsubstituted or substituted with R⁴,
R⁴ is Cl or C₁-C₄-alkyl; and
(b) a pigment derivative of formula 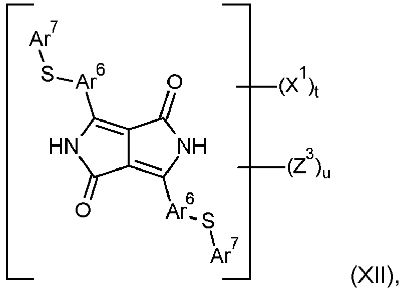 wherein
X¹ is a group comprising an aliphatic carboxamide group or an aliphatic sulfonamide group;
Ar⁶ is at each occurrence selected from phenylene or C₂-C₆-heteroarylene, said phenylene or heteroarylene is unsubstituted or substituted with R²²;
R²² is Cl, Br, C₁-C₄-alkyl, OC₁-C₄-alkyl, CF₃ or CN;
Ar⁷ is at each occurrence selected from C₆-C₁₀-aryl or C₂-C₆-heteroaryl, said aryl or heteroaryl is unsubstituted or substituted with R²³ and/or R²⁴;
R²³ and R²⁴ are independently of one another Cl, Br, C₁-C₄-alkyl, OC₁-C₄-alkyl, CF₃ or CN; or
R²³ and R²⁴ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Z² is SO₃H or a salt thereof;
t is a number of 1 to 4;
u is a number of 0 to 3; and
with the proviso that t+u is 1 to 4.

2. The pigment composition according to claim 1 , wherein the pigment composition further comprises
(c) a pigment derivative of formula
(P²) - (Y)ₙ (V)
, wherein
P² is a residue of a colorant chromophore; and
Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene;
R¹⁴ is H or C₁-C₄-alkyl; and
n is 1, 2, 3 or 4.

3. The pigment composition according to claim 1 or 2, wherein
the pigment derivative of formula
(P²) - (Y)ₙ (V)
is a diketopyrrolopyrrole derivative of formula 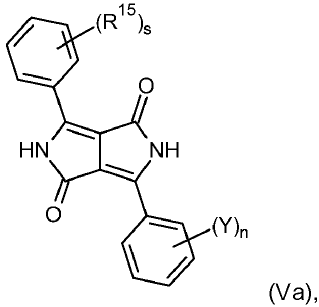 wherein
n is 1;
s is 0, 1 or 2
R¹⁵ is at each occurrence Cl, Br, CF₃, CN, C₁-C₄-alkyl, OC₁-C₄-alkyl, SC₁-C₄alkyl, Ar⁴, OAr⁴ or SAr⁴;
Ar⁴ is C₆-C₁₀-aryl or C₂-C₆-heteroaryl, said aryl or heteroaryl is unsubstituted or substituted with R¹⁶ and/or R¹⁷;
R¹⁶ and R¹⁷ are independently of one another Cl, Br, C₁-C₄-alkyl, OC₁-C₄-alkyl, CF₃ or CN; or
R¹⁶ and R¹⁷ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Y is selected from OC₈-C₂₂-alkyl, SC₈-C₂₂-alkyl, OC₁₂-C₂₂-aralkyl, SC₁₂-C₂₂-aralkyl, OC₁₂-C₂₂-alkylaryl, SC₁₂-C₂₂-alkylaryl or NR¹²R¹³,
R¹² and R¹³ are independently of one another H, C₈-C₂₂-alkyl, C₁₂-C₂₂-aralkyl, or C₁₂-C₂₂-alkylaryl;
each alkyl group in Y may be interrupted by O, S, NR¹⁴ or phenylene; and
R¹⁴ is H or C₁-C₄-alkyl.

4. The pigment composition according to claim 1, 2 or 3, wherein the amount of pigment (a) is at least 65 wt% and the amount of pigment derivative (b) is of from 3 to 35 wt%, based on the total weight of the pigment composition.

5. The pigment composition according to at least one of the preceding claims, wherein the pigment composition further comprises
(d) a pigment derivative of formula
(Z²)ₚ - (P³) - (A³- Z¹)_{q} (VI)
, wherein
P³ is a residue of a colorant chromophore,
A³ is C₁-C₆-alkylene;
Z¹ is a N-containing 5-membered heterocycle, preferably a heteroaromatic ring; and Z² is SO₃H or a salt thereof, or CO₂H or a salt thereof,
p is a number of 0 to 2; and
q is a number of 1 or 2.

6. The pigment composition according to claim 5, wherein Z¹ is a group selected from the group consisting of 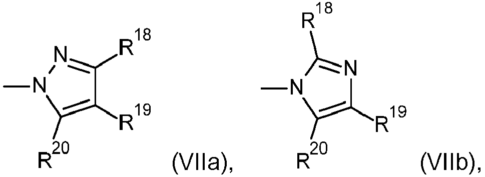 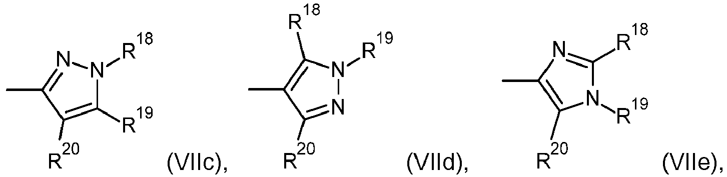 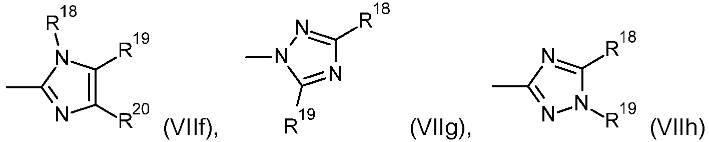 and 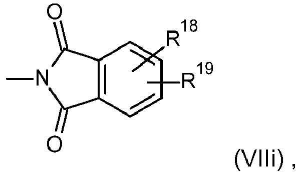 wherein
R18, R¹⁹ and R²⁰ are independently of one another H, halogen, C₁-C₁₈-alkyl; C₁-C₁₈-alkyl substituted with halogen, OC₁-C₆-alkyl or di(C₁-C₆-alkyl)amino; C₆-C₁₂-aryl; or C₆-C₁₂-aryl substituted with or C₁-C₁₈-alkyl, halogen, nitro or OC₁-C₆-alkyl;
two adjacent groups of R¹⁸, R¹⁹ and R²⁰ together with the heteroaryl ring to which they are bonded form a 5-7-membered alicyclic, aromatic or heteroaromatic ring.

7. A process for preparing a pigment composition, as defined in any one of claims 1 to 6, the process comprises reacting a succinic diester with a compound of formula NC - Ar¹ - S - Ar² (VIII), a compound of formula 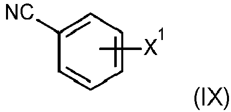 and optionally
a compound of formula 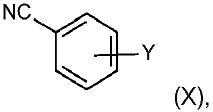 wherein
Ar¹ is phenylene or C₂-C₆-heteroarylene, said phenylene or heteroarylene is unsubstituted or substituted with R¹;
Ar² is C₆-C₁₀-aryl or C₂-C₆-heteroaryl, said aryl or heteroaryl is unsubstituted or substituted with R² and/or R³;
R¹ is Cl, Br, C₁-C₄-alkyl, OC₁-C₄-alkyl, CF₃ or CN;
R² and R³ are independently of one another Cl, Br, C₁-C₄-alkyl, OC₁-C₄-alkyl, CF₃ or CN; or
R² and R³ together with the aryl or heteroaryl ring to which they are bonded form an aromatic or heteroaromatic 5- or 6-membered ring, said aromatic or heteroaromatic ring is unsubstituted or substituted with R⁴,
R⁴ is Cl or C₁-C₄-alkyl;
X¹ is a group comprising an aliphatic carboxamide group or an aliphatic sulfonamide group;
Y is a group selected from OC₄-C₂₅-alkyl, SC₄-C₂₅-alkyl, OC₇-C₂₅-aralkyl, SC₇-C₂₅-aralkyl, OC₇-C₂₅-alkylaryl, SC₇-C₂₅-alkylaryl or NR¹²R¹³;
R¹² and R¹³ are independently of one another H, C₄-C₂₅-alkyl, C₇-C₂₅-aralkyl, or C₇-C₂₅-alkylaryl, with the proviso that the sum of carbon atoms of R¹² and R¹³ is at least 8; the alkyl group in Y may be interrupted by O, S, NR¹⁴ or phenylene; and
R¹⁴ is H or C₁-C₄-alkyl.

8. A pigment dispersion comprising a pigment composition, as defined in any one of claims 1 to 6 or obtainable according to claim 7, and a polymeric dispersant.

9. A photosensitive resist formulation comprising a pigment dispersion, as defined in claim 8, a resin, a photopolymerization initiator, an ethylenically unsaturated monomer and a solvent.

10. A color filter comprising a pigment composition, as defined in any of claims 1 to 6 or obtainable according to claim 7.

11. The use of a pigment composition, as defined in any one of claims 1 to 6 or obtainable according to claim 7, for coloring a photosensitive resist formulation for manufacturing a color filter, a printing ink, a liquid ink, a coating composition, a paint, plastics, a film or a fiber.

12. A pigment derivative of formula 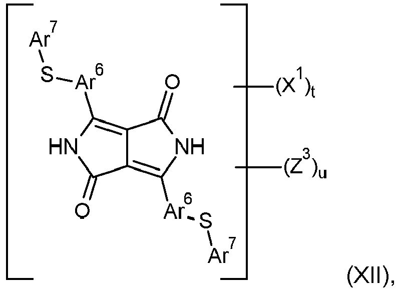 wherein
X¹ is a group comprising an aliphatic carboxamide group or an aliphatic sulfonamide group;
Ar⁶ is at each occurrence selected from phenylene or C₂-C₆-heteroarylene, said phenylene or heteroarylene is unsubstituted or substituted with R²²;
R²² is Cl, Br, C₁-C₄-alkyl, OC₁-C₄-alkyl, CF₃ or CN;
Ar⁷ is at each occurrence selected from C₆-C₁₀-aryl or C₂-C₆-heteroaryl, said aryl or heteroaryl is unsubstituted or substituted with R²³ and/or R²⁴;
R²³ and R²⁴ are independently of one another Cl, Br, C₁-C₄-alkyl, OC₁-C₄-alkyl, CF₃ or CN; or
R²³ and R²⁴ together with the aryl or heteroaryl ring to which they are bonded form an aromatic or heteroaromatic 5- or 6-membered ring, said aromatic or heteroaromatic ring is unsubstituted or substituted with Cl or C₁-C₄-alkyl;
Z² is SO₃H or a salt thereof;
t is a number of 1 to 4;
u is a number of 0 to 3; and
with the proviso that t+u is 1 to 4.
